(19) Europäisches Patentamt
European Patent Office
Office européen des brevets

(11) **EP 4 007 173 B1**

(12) **EUROPEAN PATENT SPECIFICATION**

(45) Date of publication and mention
of the grant of the patent:
**18.02.2026 Bulletin 2026/08**

(21) Application number: **20848629.0**

(22) Date of filing: **29.07.2020**

(51) International Patent Classification (IPC):
*H03M 7/30* (2006.01)    *G06F 16/51* (2019.01)
*G06N 3/04* (2023.01)

(52) Cooperative Patent Classification (CPC):
**G06F 16/51; G06N 3/0464; G06N 3/084;
G06N 3/09; H03M 7/3059; H03M 7/3082;
H03M 7/6041;** G06N 3/0409; G06N 3/044;
G06N 3/088; G06N 7/01

(86) International application number:
**PCT/CN2020/105590**

(87) International publication number:
**WO 2021/018218 (04.02.2021 Gazette 2021/05)**

(54) **DATA STORAGE METHOD AND APPARATUS THEREFOR**

DATENSPEICHERUNGSVERFAHREN SOWIE VORRICHTUNG DAFÜR

PROCÉDÉ DE STOCKAGE DE DONNÉES ET APPAREIL ASSOCIÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.07.2019 CN 201910687185**

(43) Date of publication of application:
**01.06.2022 Bulletin 2022/22**

(73) Proprietor: **Hangzhou Hikvision Digital
Technology Co., Ltd.
Hangzhou, Zhejiang 310051 (CN)**

(72) Inventors:
• **ZHANG, Yingying**
**Hangzhou, Zhejiang 310051 (CN)**
• **ZHONG, Qiaoyong**
**Hangzhou, Zhejiang 310051 (CN)**
• **XIE, Di**
**Hangzhou, Zhejiang 310051 (CN)**
• **PU, Shiliang**
**Hangzhou, Zhejiang 310051 (CN)**

(74) Representative: **BRP Renaud & Partner mbB
Rechtsanwälte Patentanwälte
Steuerberater
Königstraße 28
70173 Stuttgart (DE)**

(56) References cited:
**WO-A1-2004/061702      WO-A1-2018/106805
CN-A- 101 183 873      CN-A- 107 749 757
CN-A- 109 903 351**

• **SUN SHIJIE ET AL: "Deep Affinity Network for
Multiple Object Tracking", IEEE TRANSACTIONS
ON PATTERN ANALYSIS AND MACHINE
INTELLIGENCE, 1 January 2019 (2019-01-01),
USA, pages 1 - 1, XP055969787, ISSN: 0162-8828,
DOI: 10.1109/TPAMI.2019.2929520**
• **KUZMINYKH DENIS ET AL: "Extracting Invariant
Features From Images Using An Equivariant
Autoencoder", vol. 95, 16 October 2018
(2018-10-16), Beijing, China, pages 438 - 453,
XP055801666, Retrieved from the Internet
<URL:http://proceedings.mlr.press/v95/
kuzminykh18a/kuzminykh18a.pdf>**

EP 4 007 173 B1

- **WÓJCIK PIOTR IWO ET AL: "Training neural networks on high-dimensional data using random projection", PATTERN ANALYSIS AND APPLICATIONS, SPRINGER, NEW YORK, NY, US, vol. 22, no. 3, 19 March 2018 (2018-03-19), pages 1221 - 1231, XP036819629, ISSN: 1433-7541, [retrieved on 20180319], DOI: 10.1007/ S10044-018-0697-0**

## Description

### Technical Field

The present application relates to the data storage field, and in particular, to a data storage method and device thereof.

### Background

Data dimension refers to the descriptive attributes or characteristics of an object. For example, a picture has $16 \times 16$ pixels; each pixel has a corresponding pixel value. That is, each pixel is a descriptive attribute of the picture, and then the picture can be regarded as having 256 data dimensions.

In order to solve the problem that the storage of a picture with high data dimensions requires large storage space, auto encoders are configured to establish a one-to-one mapping relationship between low-dimensional data and high-dimensional data. In this way, based on the stored low-dimensional data, corresponding high-dimensional data can be obtained by the auto encoder, such that the storage space can be reduced. Although this type of auto encoder reduces the data storage space to a certain extent, it still needs to store a large amount of compressed low-dimensional data while storing network model parameters of the auto encoder. In this way, if the amount of data is very large, the algorithms based on the auto encoder still require a lot of storage space.

WO 2004/061702 A1 discloses methods and systems are provided for encoding, transmission and decoding of vectorized input data, for example, video or audio data. A convex invariance learning framework is established for processing input data or a given data type. Each input vector is associated with a variable transformation matrix that acts on the vector to invariantly permute the vector elements. Joint invariance and model learning is performed on a training set of invariantly transformed vectors over a constrained space of transformation matrices using maximum likelihood analysis. The maximum likelihood analysis reduces the data volume to a linear subspace volume in which the training data can be modeled by a reduced number of variables. Principal component analysis is used to identify a set of N eigen vectors that span the linear subspace. The set of N eigenvectors is used a basis set to encode input data and to decode compressed data.

How to further reduce the storage capacity of low-dimensional data corresponding to high-dimensional data is an urgent problem to be solved.

### SUMMARY

Embodiments of the present application provide a data storage method, data acquisition method and device thereof as defined in the claims, to reduce the storage space required for storing high-dimensional data.

In the embodiment of the present application, based on an N-dimensional first parameter vector, N N-dimensional second parameter vectors are obtained through affine transformation, and the second parameter vectors are mapped to N pieces of data corresponding to the first parameter vector through a trained neural network model, such that an N-dimensional first parameter vector is stored, which is equivalent to storing N pieces of data, multiple high-dimensional data is reduced to one low-dimensional data for storage, which greatly reduces the storage space required for storing high-dimensional data.

### BRIEF DESCRIPTION OF THE DRAWINGS

FIG. 1 is a flowchart of a data storage method provided by an embodiment of the present application.

FIG. 2 is a flowchart of a neural network model training method provided by an embodiment of the present application.

FIG. 3 is a schematic diagram of a data mapping process involved in an embodiment of present application.

FIG. 4 is a schematic flowchart of a data acquisition method provided by an embodiment of the present application.

FIG. 5 is a schematic diagram of a data storage device provided by an embodiment of the present application.

FIG. 6 is a schematic diagram of a data acquisition device provided by an embodiment of the present application.

## DETAILED DESCRIPTION OF THE INVENTION

In order to make the objective, technical solution and advantages of the present application more clear, the present application will be described below in detail in combination of the accompanying drawings. The invention is defined by the appended claims.

To facilitate understanding, the words appearing in the embodiments of the present application are explained below.

Affine transformation is to perform multi-dimensional permutation on a parameter vector. That is to permutate multiple dimensions of a parameter vector.

Data dimension refers to the descriptive attributes or characteristics of an object. Among them, the data dimension is referred to as "dimension" for short.

High-dimensional data is data with a higher data dimension, for example, data whose data dimension is higher than a preset threshold.

Low-dimensional data is data with a lower data dimension, for example, data whose data dimension is lower than or equal to a preset threshold. The aforementioned preset threshold can be set according to actual needs. For example, the preset threshold may be 100, 200, and so on.

A data sample is the sample data, data to be stored is simply referred to as to-be-stored data, and an adjusted first parameter vector is an updated first parameter vector.

In order to reduce the storage space required for storing high-dimensional data, an embodiment of the present application provides a data storage method, according to claim 1. A non-claimed data storage method includes:

Step 11: allocating an N-dimensional first parameter vector for N pieces of to-be-stored data;
Step 12: performing N-dimensional permutation on the first parameter vector, to obtain N second parameter vectors each having N dimensions;
Step 13, constructing a neural network model that maps the current second parameter vectors to expected data samples of the N pieces of to-be-stored data;
Step 13 is to construct a neural network model, which is configured to map the current second parameter vectors to the expected data samples of the N pieces of to-be-stored data.
Step 14: adjusting model parameters of the neural network model and/or the first parameter vector until expected data samples of the N pieces of to-be-stored data regress to the N pieces of to-be-stored data, the expected data samples being obtained from the current second parameter vectors based on the trained neural network model;
Step 14 is to adjust the model parameters of the neural network model and/or the first parameter vector until the expected data samples of the N pieces of to-be-stored data regress to the N pieces of to-be-stored data, the expected data samples being obtained by the trained neural network model based on the current second parameter vectors.
Step 15: storing the current first parameter vector.

In the embodiment of the present application, in addition to the current first parameter vector, the model parameters of the trained neural network model are stored.

The data storage method provided in this embodiment of the application allocates an N-dimensional first parameter vector to N pieces of V-dimensional to-be-stored data, where V is greater than or equal to N, and performs permutation on the N dimensions of the first parameter vector to obtain N N-dimensional second parameter vectors, so that one first parameter vector corresponds to N second parameter vectors, uses the second parameter vectors as training samples of a neural network model, and trains the neural network model and/or adjusts the first parameter vector by optimizing a loss function through iterations. Thus, the mapping relationship between the first parameter vector and the N pieces of to-be-stored data is established, such that when the N pieces to-be-stored of data are stored, the first parameter vector and the trained neural network model parameters can be stored. The embodiment of the present application performs a determined affine transformation on the first parameter vector based on the neural network model, and realizes that one low-dimensional data can represent multiple pieces of high-dimensional data, thereby greatly reducing the storage space required for storing high-dimensional data.

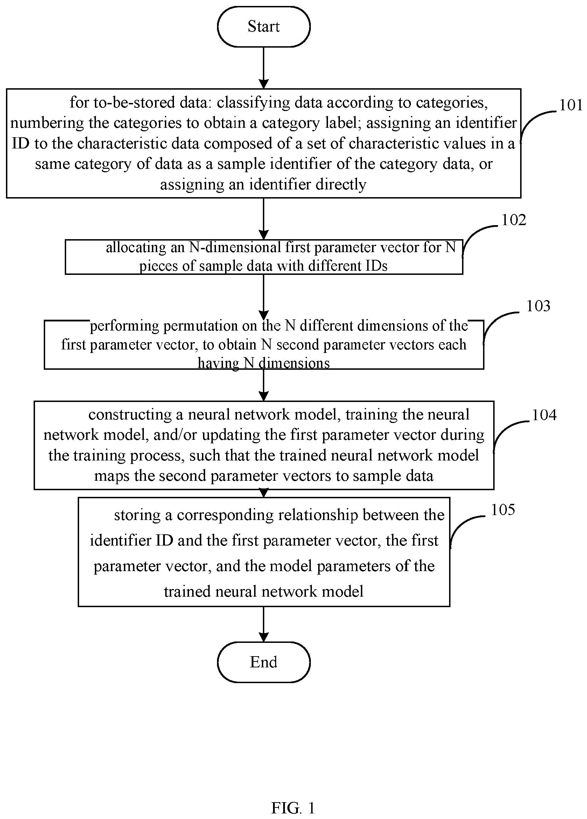

Refer to FIG. 1, FIG. 1 is a flowchart of a data storage method. The storage method includes the following steps.

Step 101: for to-be-stored data having V dimensions, for the convenience of storage and query, classifying the to-be-stored data according to categories, and numbering the categories to obtain a category label; assigning an ID (Identity) for each piece of the to-be-stored data in a same category as a sample identifier of the to-be-stored data in this category of data. Wherein, one piece of to-be-stored data is one characteristic data composed of a set of characteristic values, and one piece of characteristic data can be regarded as sample data. For example, the categories of image data may include a person category, a landscape category, etc., wherein the image data of the person category may include several pieces of sample data, such as several pieces of image data including a person.

In the embodiment of the present application, it is also possible to directly assign a sample identifier to each sample data without classifying the categories of sample data.

In the embodiment of the present application, V is a positive integer, and the to-be-stored data having V dimensions may also be referred to as V-dimensional to-be-stored data.

Step 102: allocating an N-dimensional first parameter vector $h_1$ for N pieces of sample data $\{x_1, ..., x_N\}$ with different IDs:

$$h_1 = \begin{bmatrix} b_1 \\ b_2 \\ ... \\ b_N \end{bmatrix}$$

The initial value $\{b_1, ....., b_N\}$ of the first parameter vector can be obtained by sampling according to Gaussian distribution random values, N is a positive integer, and V is greater than or equal to N. Optionally, V is greater than N.

In the embodiment of the present application, the initial values of the parameters of each dimension in the first parameter vector are obtained by sampling N pieces of to-be-stored data according to Gaussian distribution random values. At this time, the value of the first parameter vector in each dimension are different.

Step 103: performing permutation on the N different dimensions of the first parameter vector, to obtain N second parameter vectors $h_k$ each having N dimensions, so that the first parameter vector can correspond to N samples.

The above step 103 is to perform N-dimensional permutation on the first parameter vector to obtain N second parameter vectors $h_k$ each having N dimensions, so that the first parameter vector can correspond to the N second parameter vectors.

In the embodiment of the present application, the following formula can be configured to perform N-dimensional permutation on the first parameter vector:

$$h_k = A_k h_1, \qquad k = 1, ..., N$$

wherein, $h_k$ represents the second parameter vectors, $h_1$ represents the first parameter vector, $A_k$ represents the affine transformation matrix, $A_k \in R^{N \times N}$, $R^{N \times N}$ represents a set of N×N-dimensional matrices, element $a_{ij}$ in the i-th row and j-th column in $A_k$ can be expressed by the following formula:

$$a_{ij} = \begin{cases} 1, & j \geq k \text{ and } j - i = k - 1 \\ 1, & j < k \text{ and } j - i = k - 1 - N \\ 0, & \text{other} \end{cases}.$$

In the above affine transformation matrix,

When k=1, the affine transformation matrix $A_k$ is the identity matrix. At this time, the second parameter vectors $h_k$ is the first parameter vector $h_1$.

When $k \neq 1$, the affine transformation matrix $A_k$ is equivalent to the matrix obtained by putting the elements in the first k-1 row of $A_1$ to the end of $A_1$. After the above affine transformation, the second parameter vectors $h_k$ is equivalent to the parameter vector obtained by putting the first k-1 elements of $h_1$ to the end of $h_1$.

In the embodiment of the present application, k may be an identifier of the sample data, or it may be obtained by transforming the identifier of the sample data according to a certain rule. Based on a value of $k$, an affine transformation matrix $A_k$ and a second parameter vectors $h_k$ can be obtained. That is, the affine transformation matrix $A_k$ has a one-to-one corresponding relationship with the second parameter vectors $h_k$, and the second parameter vectors has a one-to-one corresponding relationship with the to-be-stored data. Therefore, the to-be-stored data has a one-to-one corresponding relationship with the affine transformation matrix.

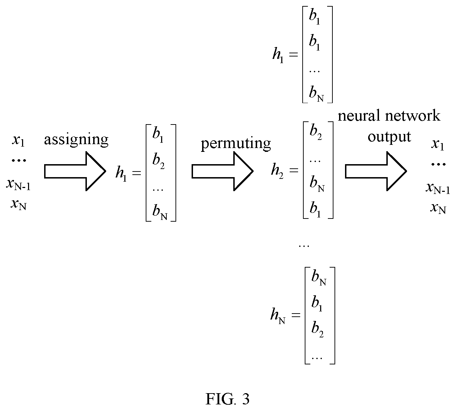

The second parameter vectors obtained by the above affine transformation, except for the second parameter vectors when k=1, the values of the other second parameter vectors in each dimension are different from the a value of the first parameter vector in the corresponding dimension, such as shown in Fig. 3. This affine transformation method establishes a mapping relationship from a low-dimensional parameter vector $h_1$ to N pieces of high-dimensional sample data $\{x_1, ..., x_N\}$, which maximizes the difference between the first parameter vector and the second parameter vectors, facilitating the representation of different sample data. In the embodiment of the present application, through this mapping relationship, a low-dimensional first parameter vector can be directly stored, and then high-dimensional sample data can be restored by the first parameter vector via the above mapping relationship. Since a low-dimensional parameter vector can be mapped to obtain N pieces of high-dimensional sample data, and the number of dimensions of the low-dimensional parameter vector is lower than that of the high-dimensional sample data, the storage space required for storing high-dimensional data is greatly compressed.

In the embodiment of the present application, the ID of the sample data may be numbered in the order of 1 to N. In this way, the above-mentioned affine transformation matrix can be generated online according to the value of $k$ or the IDs of the sample data. In this way, the affine transformation matrix does not need to occupy storage space. In addition, the affine transformation matrix may also be in other forms, as long as the affine transformation matrix is generated according to a preset rule. For example, the element $a_{ij}$ of the affine transformation matrix $A_k \in R^{N \times N}$ can also be:

$$a_{1k} = 1$$

$$a_{k1} = 1$$

$$a_{ij} = \begin{cases} 1, & i \neq 1, k \text{ , and } i = j \\ 0, & other \end{cases}.$$

After the above affine transformation, the second parameter vectors $h_k$ is equivalent to the parameter vector obtained by exchanging the k-th element of $h_1$ and the first element of h1.

Step 104: constructing a neural network model, training the neural network model, and/or updating the first parameter vector during the training process, such that the trained neural network model $f$ maps the second parameter vectors $h_k$ to sample data $x_k$:

$$x_k = f(h_k).$$

Wherein, $f$ represents the trained neural network model, the second parameter vectors $h_k$ is the input variable of the trained neural network model, and $x_k$ is the output data of the trained neural network model. The above neural network model can be a deep neural network model, error back propagation (BP) neural network model, recurrent neural network model (Hopfield neural network model), adaptive resonance theory (ART) neural network Model or Self-Organizing Feature Mapping (SOM) neural network model, etc. The details can be determined according to the characteristics of the sample data.

Step 105: storing a corresponding relationship between the identifier ID and the first parameter vector, the first parameter vector, and the model parameters of the trained neural network model.

Step 105 is that, in step 105, the corresponding relationship between the sample IDs of the N pieces of sample data used for training the neural network model and the first parameter vector is stored, and the first parameter vector and the model parameters of the trained neural network model are stored.

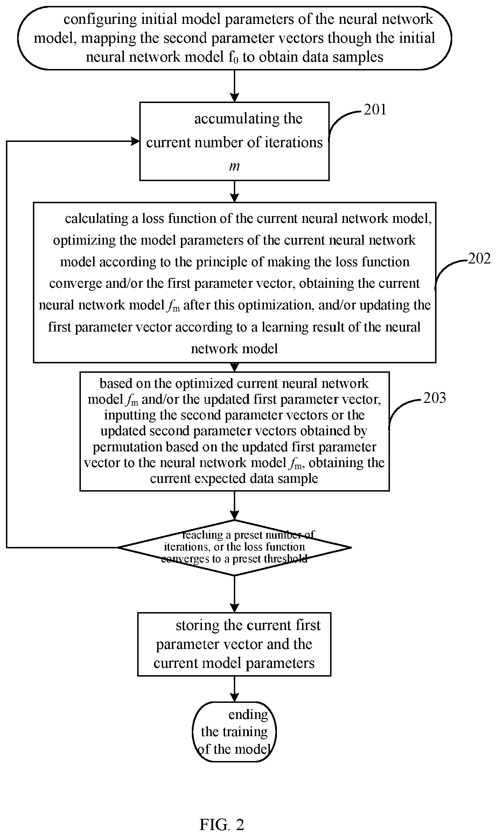

In an implementation, referring to FIG. 2, FIG. 2 is a flowchart of a neural network model training method provided by an embodiment of the application.

The initial model parameters in the neural network model are configured, and sample mapping on the second parameter vectors $h_k$ through the neural network model $f_0$ is performed to obtain the data sample $\hat{x}_k$:

$$\hat{x}_k = f_0(h_k).$$

Wherein, $f_0$ represents the initial neural network model, and $\hat{x}_k$ is the expected data sample recovered by the neural network model. The goal of training the neural network model is to make the expected data sample $\hat{x}_k$ as close as possible to the real data sample $x_k$.

The training method for the constructed neural network model may include the following steps.

Step 201, accumulating the current number of iterations.

Step 202: calculating a loss function of the current neural network model, optimizing the model parameters of the current neural network model according to the principle of making the loss function converge, obtaining the current neural network model $f_m$ (m represents the number of iterations) after this optimization, and/or updating the first parameter vector according to a learning result of the neural network model, such that the first parameter vector becomes a learnable parameter vector. The calculation of the loss function can be:

$$\mathcal{L} = \sum \|\hat{x}_k - x_k\|_2^2.$$

Wherein, $\mathcal{L}$ represents the loss function. In the embodiment of the present application, the loss function is the sum of the squared Euclidean distances of two vectors (expected data sample and real data sample); $\hat{x}_k$ is the expected data sample, and $x_k$ is the real data sample, such as the to-be-stored data described above.

The aforementioned loss function may also be a type of regression loss function. For example, the aforementioned loss function may be a mean squared error loss function, a mean absolute error loss function, a smooth mean absolute error loss function, a log-hyperbolic cosine (Log-Cosh) loss function, or a quantile loss function. Specifically, it can be determined according to factors such as the characteristics of the sample data, the neural network model used, the efficiency of the iteration, and the expected data sample obtained during each iteration.

Step 203: based on the optimized current neural network model $f_m$ and/or the updated first parameter vector, inputting the second parameter vectors or the updated second parameter vectors obtained by permutation based on the updated first parameter vector to the neural network model $f_m$, to obtain the current expected data sample $\hat{x}_k$:

$$\hat{x}_k = f_m(h_k).$$

Step 203 is to input the current second parameter vectors into the neural network model $f_m$ based on the optimized current neural network model $f_m$ and/or the updated first parameter vector to obtain the current expected data sample $\hat{x}_k$. Wherein, the current second parameter vectors is the second parameter vectors after the previous iteration, or the current second parameter vectors is the second parameter vectors obtained by performing N-dimensional permutation on the updated first parameter vector.

Return to step 201, until the current number of iterations reaches a predetermined number of iterations, and/or the loss function converges to a set threshold, storing the current first parameter vector and the current model parameters, and storing the corresponding relationship between the IDs of the N pieces of sample data and the current first parameter vector.

When the training of neural network model is over, for N data samples, only the final first parameter vector after learning, the corresponding relationship between the IDs of the N pieces of sample data and the final first parameter vector, and the model parameters of the trained neural network need to be stored, thus realizing that one low-dimensional data can represent multiple pieces of high-dimensional data, thereby greatly reducing the storage space required for storing high-dimensional data.

The above step 203 can be specifically divided into the following cases:

In a first case, if the current neural network model $f_m$ is optimized and the first parameter vector is not updated, then load the optimized model parameters for the neural network model $f_m$, to obtain the optimized neural network model $f_m$; input the second parameter vectors of the previous iteration to the optimized neural network model $f_m$, to obtain the current expected data sample $\hat{x}_k$.

In a second case, if the first parameter vector is updated and the current neural network model $f_m$ is not optimized, then perform N-dimensional permutation on the updated first parameter vector, to obtain the updated second parameter vectors, input the updated second parameter vectors to the current neural network model $f_m$, to obtain the current expected data sample $\hat{x}_k$.

In a third case, if the current neural network model $f_m$ is optimized and the first parameter vector is updated, then perform N-dimensional permutation on the updated first parameter vector, to obtain the updated second parameter vectors, input the updated second parameter vectors to the optimized current neural network model $f_m$, to obtain the current expected data sample $\hat{x}_k$.

After obtaining the expected data sample $\hat{x}_k$, it is judged whether the current number of iterations reaches the predetermined number of iterations, and it is judged whether the loss function converges to the set threshold. If the current number of iterations does not reach the predetermined number of iterations, and the loss function does not converge to the set threshold, then return to step 201. If the current number of iterations reaches the predetermined number of iterations, and/or the loss function converges to the set threshold, then the current first parameter vector and current model parameters are saved, and the corresponding relationship between the IDs of the N data samples and the current first parameter vector are saved. Here, if the current number of iterations reaches the predetermined number of iterations, and/or the loss function converges to the set threshold, then the current first parameter vector is saved as the final updated first parameter vector, and the current model parameters are the final optimized model parameters.

In the embodiment of the present application, the execution order of the foregoing steps 203 and 202 is not limited. For example, step 203 may be performed first, and then step 202 may be performed.

Referring to FIG. 3, FIG. 3 is a schematic diagram of a data mapping process involved in an embodiment of the present application. Wherein, an N-dimensional first parameter vector is subjected to N-dimensional permutation through an affine transformation matrix to obtain N second parameter vectors each having N dimensions, and the N second parameter vectors are respectively input to the trained neural network model, thus N data samples {x1,...,xN} after mapping can be obtained.

Corresponding to the foregoing data storage method, an example useful for understanding the invention provides a data acquisition method, including:

obtaining a stored first parameter vector according to information of to-be- acquired data;

performing N-dimensional permutation on the first parameter vector to obtain N-dimensional second parameter vectors corresponding to the to-be- acquired data, where N is the number of dimensions of the first parameter vector;

obtaining a trained neural network model used for data storage;

using the second parameter vectors as input variables of the trained neural network model, and using output data of the trained neural network model as the to-be- acquired data.

In the embodiment of the present application, the trained neural network model is the neural network model obtained after training in the above-mentioned data storage method. For the training process of the trained neural network model, refer to the description of the above-mentioned FIGS. 1-2 for details.

In an embodiment, the foregoing obtaining a stored first parameter vector according to information of to-be-acquired data may include:

obtaining the first parameter vector according to categories and/or identifiers of the to-be-acquired data based on a corresponding relationship between the stored categories and/or identifiers and the first parameter vector;

obtaining a trained neural network model used for data storage, including: obtaining the stored model parameters of the trained neural network model, and loading the obtained model parameters into the neural network model to obtain the trained neural network model.

In an embodiment, performing N-dimensional permutation on the first parameter vector to obtain N-dimensional second parameter vectors corresponding to the to-be-acquired data may include: performing N-dimensional permutation on the first parameter vector according to the affine transformation matrix corresponding to the to-be- acquired data, to obtain the N-dimensional second parameter vectors corresponding to the to-be-acquired data.

In an embodiment, performing N-dimensional permutation on the first parameter vector according to the affine transformation matrix corresponding to the to-be- acquired data, to obtain the N-dimensional second parameter vectors corresponding to the to-be-acquired data may include:

performing N-dimensional permutation on the first parameter vector according to an affine transformation matrix corresponding to the to-be- acquired data, such that: when the affine transformation matrix corresponding to the to-be- acquired data is the k-th affine transformation matrix, when $k$ is equal to 1, the N-dimensional second parameter vector corresponding to the to-be- acquired data is equal to the first parameter vector; when $k$ is not equal to 1, the second parameter vectors are obtained by placing the first $k$-1 elements of the first parameter vector to the end of the first parameter vector, wherein $k$=1,...N.

In an embodiment, performing N-dimensional permutation on the first parameter vector according to the affine transformation matrix corresponding to the to-be- acquired data may include:

multiplying the affine transformation matrix corresponding to the to-be- acquired data by the first parameter vector;

wherein, the affine transformation matrix is an N×N matrix, when the affine transformation matrix corresponding to the to-be- acquired data is the k-th affine transformation matrix, the element $a_{ij}$ in each of the N affine transformation matrices corresponding to the to-be- acquired data satisfies:

$$a_{ij} = \begin{cases} 1, & j \geq k \ \text{and} \ j-i \ = \ k-1 \\ 1, & j < k \ \ and \ \ j-i \ = \ k-1-\text{N} \\ 0, & \text{other} \end{cases}.$$

In an embodiment, performing N-dimensional permutation on the first parameter vector to obtain the N-dimensional second parameter vectors corresponding to the to-be-acquired data may include:

exchanging the value of the dimension corresponding to the identifier of the to-be-acquired data in the first parameter vector with the value of the first dimension in the first parameter vector, to obtain the N-dimensional second parameter vectors corresponding to the to-be-acquired data.

In an embodiment, exchanging the value of the dimension corresponding to the identifier of the to-be-acquired data in the first parameter vector with the value of the first dimension in the first parameter vector, to obtain the N-dimensional second parameter vectors corresponding to the to-be-acquired data may include:

performing N-dimensional permutation on the first parameter vector according to the affine transformation matrix corresponding to the to-be- acquired data, such that: when the affine transformation matrix corresponding to the to-be- acquired data is the $k$-th affine transformation matrix, when k is equal to 1, the N-dimensional second parameter vector corresponding to the to-be- acquired data is equal to the first parameter vector; when k is not equal to 1, the N-dimensional second parameter vectors corresponding to the to-be-acquired data are obtained by exchanging the k-th element of the first parameter vector with the first element, wherein $k=1,...N$, $k$ represents the identifier of the to-be-acquired data.

In an embodiment, performing N-dimensional permutation on the first parameter vector according to the affine transformation matrix corresponding to the to-be- acquired data may include:

multiplying the affine transformation matrix corresponding to the to-be- acquired data by the first parameter vector;

wherein, the affine transformation matrix is an N×N matrix, when the affine transformation matrix corresponding to the to-be- acquired data is the k-th affine transformation matrix, the element $a_{ij}$ in each of the N affine transformation matrices corresponding to the to-be- acquired data satisfies:

$$a_{1k} = 1;$$

$$a_{k1} = 1;$$

$$a_{ij} = \begin{cases} 1, & i \neq 1, k, \text{and } i = j \\ 0, & \text{other} \end{cases}$$

The above data acquisition method is a data acquisition method corresponding to the above data storage method. Therefore, the description of the above data acquisition method part is relatively simple, and reference can be made to the corresponding part of the description of the above data storage method.

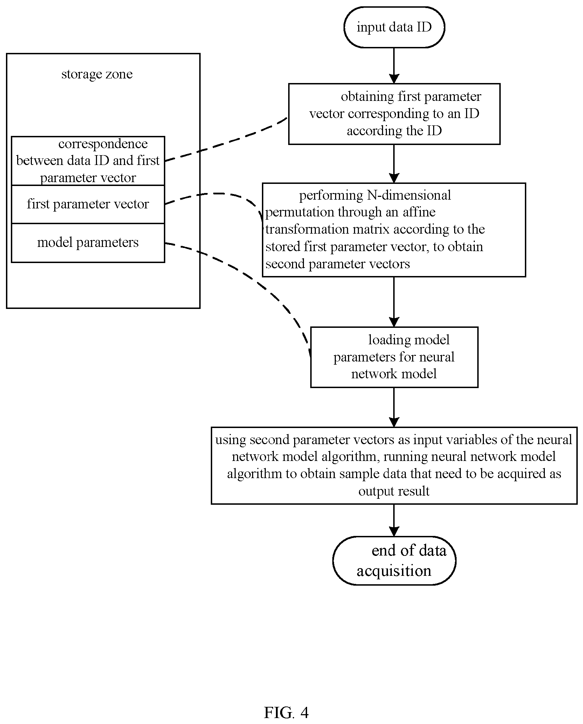

Referring to FIG. 4, FIG. 4 is a schematic flowchart of a data acquisition method provided by an embodiment of the present application.

When the sample data needs to be acquired, according to an identifier of the sample data that needs to be acquired, the first parameter vector corresponding to the identifier is obtained. For the convenience of description, this step is referred to as step 41.

In the embodiment of the present application, a one-to-one corresponding relationship between categories and the first parameter vector may be stored, and the corresponding relationship between multiple identifiers and the first parameter vector may also be stored, that is, one first parameter vector corresponds to multiple identifiers. The first parameter vector corresponding to the category can be obtained according to the category of the sample data that needs to be acquired, and the obtained first parameter vector is used as the first parameter vector corresponding to the sample data that needs to be acquired. It is also possible to obtain the first parameter vector corresponding to an identifier according to the identifier of the sample data that needs to be acquired, and the obtained first parameter vector is used as the first parameter vector corresponding to the sample data that needs to be acquired.

In step 41, the sample data that needs to be acquired is the to-be-acquired data, and step 41 is to acquire the stored first parameter vector according to the information of the to-be-acquired data.

The second parameter vector is obtained by performing N-dimensional permutation through the affine transformation matrix according to the stored first parameter vector. The specific calculation formula is the same as in step 103. For the convenience of description, this step is referred to as step 42.

Step 42 is to perform N-dimensional permutation on the first parameter vector through the affine transformation matrix to obtain N second parameter vectors each having N dimensions.

The neural network model is loaded with the stored model parameters, that is, the neural network model used for data storage is invoked, the stored model parameters are configured to be assign to the neural network model, and the second parameter vectors are used as the input variables of the neural network model, the output result of the neural network model is the sample data that needs to be acquired. For the convenience of description, this step is referred to as step 43.

Optionally, the obtaining a stored first parameter vector according to information of to-be- acquired data may include:

obtaining the first parameter vector according to categories and/or identifiers of the to-be-acquired data based on a corresponding relationship between the stored categories and/or identifiers and the first parameter vector;

obtaining a trained neural network model used for data storage, including: obtaining the stored model parameters of the trained neural network model, and loading the obtained model parameters into the neural network model to obtain the trained neural network model.

Optionally, the performing N-dimensional permutation on the first parameter vector to obtain N second parameter vectors each having N dimensions may include: performing N-dimensional replacement on the first parameter vector through N affine transformation matrices to obtain N second parameter vectors each having N dimensions, such that one of the N second parameter vectors each having N dimensions is the same as the first parameter vector, and values of the other second parameter vectors in each dimension are different from a value of the first parameter vector in the corresponding dimension.

Optionally, the performing N-dimensional replacement on the first parameter vector through N affine transformation matrices to obtain N second parameter vectors each having N dimensions, such that one of the N second parameter vectors each having N dimensions is the same as the first parameter vector, and values of the other second parameter vectors in each dimension are different from a value of the first parameter vector in the corresponding dimension may include:

performing N-dimensional permutation on the first parameter vector through N affine transformation matrices respectively, such that for the k-th affine transformation matrix, when k is equal to 1, the second parameter vector is equal to the first parameter vector; when k is not equal to 1, the first k-1 elements of the first parameter vector are placed at the end of the first parameter respectively, to obtain N-1 second parameter vectors each having N dimensions, where k=1,...N.

Optionally, the performing N-dimensional permutation on the first parameter vector through N affine transformation matrices may include:

multiplying the N affine transformation matrices by the first parameter vector respectively;

wherein, the N affine transformation matrices are N×N matrices respectively, and the element $a_{ij}$ in each of the N affine transformation matrices satisfies:

$$a_{ij} = \begin{cases} 1, & j \geq k \ \ and \ \ j - i \ = \ k - 1 \\ 1, & j < k \ \ and \ \ j - i \ = \ k - 1 - \mathrm{N} \\ 0, & other \end{cases}.$$

Optionally, the performing N-dimensional permutation on the first parameter vector to obtain N second parameter vectors each having N dimensions may include:

exchanging a value of a dimension corresponding to the identifier of the to-be-acquired data in the first parameter vector with a value of a first dimension in the first parameter vector, to obtain N second parameter vectors each having N dimensions.

Optionally, the exchanging a value of a dimension corresponding to the identifier of the to-be- acquired data in the first parameter vector with a value of a first dimension in the first parameter vector, to obtain N second parameter vectors each having N dimensions may include:

performing N-dimensional permutation on the first parameter vector through N affine transformation matrices respectively, such that for the k-th affine transformation matrix, when k is equal to 1, the second parameter vector is equal to the first parameter vector; when k is not equal to 1, the k-th element of the first parameter vector is exchanged with the first element, to obtain N-1 second parameter vectors each having N dimensions, where k represents the identifier of to-be-acquired data, k=1,...N.

Optionally, the performing N-dimensional permutation on the first parameter vector through N affine transformation matrices respectively includes:

multiplying the N affine transformation matrices by the first parameter vector respectively;

wherein, the N affine transformation matrices are N×N matrices respectively, and the element $a_{ij}$ in each of the N affine transformation matrices satisfies:

$$a_{1k} = 1 \ ;$$

$$a_{k1} = 1 \; ;$$

$$a_{ij} = \begin{cases} 1, & i \neq 1, k, \, and \; i = j \\ 0, & other \end{cases}.$$

Through the above steps, the embodiment of the present application can quickly query the to-be-acquired data, with high data acquisition efficiency and convenient use.

To illustrate the embodiments of the present application, the storage of image data will be described as an embodiment below.

Image data includes a large number of pixels and the pixel value of each pixel, which is one of the typical high-dimensional data. For example, in an incremental learning scenario, a large number of feature maps of the images output by the middle layer of a convolutional neural network need to be used. At this time, the image data included in the feature map has a very high dimension. If the image data included in the feature map is stored directly, it will consume storage space very much.

Assume that the to-be-stored image data includes 10 pieces of image data, and each image data includes pixel values of $16\times16$ pixels. According to the description of the embodiments of the present application, the to-be-stored image data includes sample data with 10 different IDs, and each sample data includes 256 data dimensions.

A 10-dimensional first parameter vector $h_1$ is allocated to the 10 pieces of image data, and the initial values of the parameters in the vector are obtained by sampling the 10 pieces of sample data according to Gaussian distribution random values.

By performing permutation on the 10 dimensions of the first parameter vector, 10 second parameter vectors $\{h_1,...,h_{10}\}$ each having 10 dimensions are obtained.

A deep learning neural network model is constructed and the deep learning neural network model is trained so that the trained deep learning neural network model $f$ can map 10 10-dimensional second parameter vectors $\{h_1,...,h_{10}\}$ to 10 pieces of image data.

Wherein, the process of training the constructed deep learning neural network model may include configuring each initial model parameter in the deep learning neural network model, and using the deep learning neural network model $f_0$ to perform mapping on the second parameter vectors $\{h_1,...,h_{10}\}$, to obtain expected data samples of 10 pieces of image data, that is, the expected image data $\{\hat{x}_1, \hat{x}_2, ..., \hat{x}_{10}\}$:

$$\hat{x}_k = f_0(h_k).$$

Wherein, $f_0$ represents the initial deep learning neural network model, $\hat{x}_k$ is the expected image data of the k-th piece of image data output by the deep learning neural network model, $k=1,2,...10$.

The current number of iterations is accumulated.

A loss function of the current deep learning neural network model is calculated, the model parameters of the current deep learning neural network model are optimized according to the principle of making the loss function converge, and the current deep learning neural network model $f_m$ (m represents the number of iterations) is obtained after this optimization, and/or the first parameter vector is updated according to the learning result of the deep learning neural network model, so that the first parameter vector becomes a learnable parameter vector. The calculation of the above loss function can be:

$$\mathcal{L} = \sum_{k=1}^{10} \|\hat{x}_k - x_k\|_2^2.$$

Wherein, $\mathcal{L}$ represents the loss function, $x_k$ is the image data of the k-th to-be-stored image, and $\hat{x}_k$ is the expected image data of the k-th piece of image data.

Based on the optimized current deep learning neural network model $f_m$ and/or the updated first parameter vector, the current second parameter vector is input to the deep learning neural network model $f_m$ to obtain current expected image data. Wherein, the current second parameter vector can be the second parameter vector after the previous iteration; the current second parameter vector can also be obtained by performing N-dimensional permutation on the updated first parameter vector.

Return to the step of accumulating the current number of iterations until a predetermined number of iterations is reached, and/or the loss function converges to a set threshold.

After the training of the deep learning neural network model is completed, for 10 pieces of image data, only the 10 values of the final first parameter vector after learning and the model parameters of the trained deep learning neural network model need to be stored. For the 10 pieces of to-be-stored image data, there are actually 2560 pixel values that need to be stored. It can be seen that the technical solution provided by the embodiments of the present application can greatly compress the data storage space.

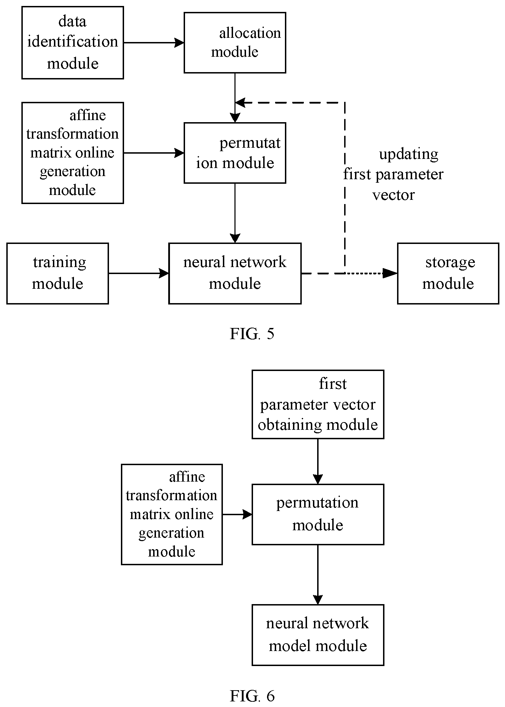

Referring to FIG. 5, FIG. 5 is a schematic diagram of a data storage device according to an embodiment of the application. The device includes:

an allocation module, configured to allocate an N-dimensional first parameter vector for N pieces of to-be-stored data having at least V dimensions; wherein, initial values of each dimension of the first parameter vector are obtained by sampling N pieces of to-be-stored data respectively according to Gaussian distribution random values, V and N are natural numbers, and V is greater than or equal to N. Optionally, V is greater than or equal to N;

a permutation module, configured to perform N-dimensional permutation on the first parameter vector, to obtain N second parameter vectors each having N dimensions;

a neural network module, configured to construct a neural network model that maps the current second parameter vectors to expected data samples of the N pieces of to-be-stored data, adjust model parameters of the neural network model and/or the first parameter vector until the expected data samples of the N pieces of to-be-stored data regress to the N pieces of to-be-stored data, the expected data samples being obtained from the current second parameter vectors based on the trained neural network model;

a storage module, configured to store the current first parameter vector, the model parameters of the trained neural network model.

The above-mentioned neural network module can by referred to as a construction module.

In the embodiment of this application, for the to-be-stored data, such as image data, it contains a larger data dimension, and the N pieces of to-be-stored data with a higher storage dimension are replaced with the first parameter vector with a lower storage dimension, which saves a lot of storage space and reduces the amount of calculations.

In an embodiment, the neural network module may also be configured to: if the expected data samples of the N pieces of to-be-stored data do not regress to the N pieces of to-be-stored data, then perform N-dimensional permutation on the current first parameter vector, and return to execute the step of adjusting the model parameters of the neural network model and/or the first parameter vector, wherein the expected data samples are obtained from the current second parameter vectors based on the trained neural network model.

In an embodiment, the data storage device may further include:
a data identification module, configured to classify the N pieces of to-be-stored data according to categories, and/or assign an identifier for each piece of the to-be-stored data and store a corresponding relationship between the category and/or identifier of the N pieces to-be-stored data and the first parameter vector.

In an embodiment, the permutation module may be specifically configured to perform N-dimensional permutation on the first parameter vector through N affine transformation matrices to obtain N second parameter vectors each having N dimensions, such that one of the N second parameter vectors each having N dimensions is the same as the first parameter vector, and values of the other second parameter vectors in each dimension are different from a value of the first parameter vector in the corresponding dimension.

For example, perform N-dimensional permutation on the first parameter vector through N affine transformation matrices respectively. For the k-th affine transformation matrix, when k is equal to 1, the second parameter vector is equal to the first parameter vector; when k is not equal to 1, the first k-1 elements of the first parameter vector are placed at the end of the first parameter respectively, to obtain N-1 second parameter vectors each having N dimensions, where k=1,...N.

In an embodiment, the permutation module may be specifically configured to exchange the value of the dimension corresponding to the identifier of the N pieces of to-be-acquired data in the first parameter vector with the value of the first dimension in the first parameter vector, to obtain N second parameter vectors each having N dimensions.

For example, perform N-dimensional permutation on the first parameter vector according to N affine transformation matrices respectively, when k is equal to 1, the second parameter vector is equal to the first parameter vector; when k is not equal to 1, exchange the k-th element of the first parameter vector with the first element, wherein k=1,...N.

In an embodiment, the permutation module may include an affine transformation matrix online generation module, which is configured to generate each affine transformation matrix online according to a preset transformation rule.

In an embodiment, the neural network module may be specifically configured to train the module parameters of the neural network module by using the N second parameter vectors each having N dimensions as input variables of the trained neural network model and using output data of the neural network model as the expected data samples of the N pieces of to-be-stored data, and/or adjust the first parameter vector during the training process until the expected data samples of the N pieces of to-be-stored data regress to the N pieces of to-be-stored data.

In an embodiment, the device may further include a training module, configured to:

initialize the model parameters of the neural network model;

accumulate the current number of iterations;

input the current second parameter vectors into the current neural network model to obtain current expected data samples of the N pieces of to-be-stored data, calculate a loss function of the current expected data sample and the to-be-stored data, and optimize the current model parameters and/or the first parameter vector of the neural network model according to the principle of making the loss function converge, to obtain the model parameters of the neural network model optimized for this iteration and/or the updated first parameter vector;

use the second parameter vectors after the previous iteration as the current second parameter vectors, or perform N-dimensional permutation on the adjusted first parameter vector to obtain the second parameter vectors, which are used as the current second parameter vectors;

return to execute the step of accumulating the current number of iterations until the current number of iterations reaches a predetermined number of iterations, or the loss function converges to a predetermined threshold, to obtain the model parameters of the trained neural network model and/or the updated first parameter vector.

In an embodiment, the neural network model is a deep learning neural network model.
Referring to FIG. 6, FIG. 6 is a schematic diagram of a data acquisition device provided by an embodiment of the present application. The device includes:

a first parameter vector obtaining module, configured to obtain a stored first parameter vector according to information of to-be- acquired data;

a permutation module, configured to perform N-dimensional permutation on the first parameter vector to obtain N second parameter vectors each having N dimensions, where N is the number of dimensions of the first parameter vector, that is N is the number of data dimensions included in the first parameter vector;

a neural network model module, configured to obtain a trained neural network model used for data storage; use the N second parameter vectors as input variables of the trained neural network model, and use output data of the trained neural network model as the to-be-acquired data.

The aforementioned first parameter vector obtaining module may also be called a first obtaining module, and the neural network model module may be called a second obtaining module.
In an embodiment, the first parameter vector obtaining module may be specifically configured to obtain the first parameter vector according to categories and/or identifiers of the to-be-acquired data based on a corresponding relationship between the stored categories and/or identifiers and the first parameter vector;
The neural network model module may be specifically configured to obtain the stored model parameters of the trained neural network model, and load the obtained model parameters into the neural network model to obtain the trained neural network model.
In an embodiment, the permutation module may be specifically configured to perform N-dimensional permutation on the first parameter vector through N affine transformation matrices to obtain N second parameter vectors each having N dimensions, such that one of the N second parameter vectors each having N dimensions is the same as the first parameter vector, and values of the other second parameter vectors in each dimension are different from a value of the first parameter vector in the corresponding dimension.
For example, for the k-th affine transformation matrix, when k is equal to 1, the second parameter vector is equal to the first parameter vector; when k is not equal to 1, the first *k-1* elements of the first parameter vector are placed at the end of the first parameter respectively, to obtain N-1 second parameter vectors each having N dimensions, where *k*=1,...N.
In an embodiment, the permutation module may be specifically configured to the exchange the value of the dimension corresponding to the identifier of the to-be-acquired data in the first parameter vector with the value of the first dimension in the first parameter vector, to obtain N second parameter vectors each having N dimensions.
For example, for the k-th affine transformation matrix, when k is equal to 1, the second parameter vector is equal to the first parameter vector; when k is not equal to 1, the k-th element of the first parameter vector is exchanged with the first element, to obtain N-1 second parameter vectors each having N dimensions, where k represents the identifier of to-be-acquired data, *k*=1,...N.

In an embodiment, the permutation module may further include an affine transformation matrix online generation module, which is configured to generate each affine transformation matrix online according to a preset transformation rule.

An embodiment of the present application also provides a data storage device, which is characterized in that the device includes a memory and a processor, wherein the memory is configured to store instructions that, when executed by the processor, cause the processor to implement the steps of the data storage method.

An embodiment of the present application also provides a data acquisition device, which is characterized in that the device includes a memory and a processor, wherein the memory is configured to store instructions that, when executed by the processor, cause the processor to implement the steps of the data acquisition method.

The memory may include random access memory (RAM), and may also include non-volatile memory (NVM), such as at least one disk memory. Optionally, the memory may also be at least one storage device located far away from the foregoing processor.

The above-mentioned processor may be a general-purpose processor, including a central processing unit (CPU), a network processor (NP), etc.; it may also be a digital signal processor (DSP), an application specific integrated circuit (ASIC), Field-Programmable Gate Array (FPGA) or other programmable logic devices, discrete gates or transistor logic devices, discrete hardware components.

An embodiment of the present application also provides a data acquisition device, according to claim 10. In a non-claimed embodiment the device includes

a first obtaining module, configured to obtain a stored first parameter vector according to information of to-be- acquired data;

configured to perform N-dimensional replacement on the first parameter vector to obtain N-dimensional second parameter vectors corresponding to the to-be-acquired data, where N is the number of dimensions of the first parameter vector;

a replacement module, configured to obtain a trained neural network model used for data storage;

a second obtaining module, configured to use the second parameter vectors as input variables of the trained neural network model, and use output data of the trained neural network model as the to-be- acquired data.

In an embodiment, the above first obtaining module may be specifically configured to: obtain the first parameter vector according to categories and/or identifiers of the to-be-acquired data based on a corresponding relationship between the stored categories and/or identifiers and the first parameter vector;

the second obtaining module may be specifically configured to obtain the stored model parameters of the trained neural network model, and load the obtained model parameters into the neural network model to obtain the trained neural network model.

In an embodiment, the above permutation module may be specifically configured to perform N-dimensional permutation on the first parameter vector through an affine transformation matrix corresponding to the to-be-acquired data, to obtain N-dimensional second parameter vectors corresponding to the to-be-acquired data.

In an embodiment, the above permutation module may be specifically configured to:

perform N-dimensional permutation on the first parameter vector according to an affine transformation matrix corresponding to the to-be- acquired data, such that: when the affine transformation matrix corresponding to the to-be- acquired data is the k-th affine transformation matrix, when k is equal to 1, the N-dimensional second parameter vector corresponding to the to-be- acquired data is equal to the first parameter vector; when k is not equal to 1, the second parameter vectors are obtained by placing the first k-1 elements of the first parameter vector to the end of the first parameter vector, wherein $k=1,...N$.

In an embodiment, the permutation module may be specifically configured to:

multiply the affine transformation matrix corresponding to the to-be- acquired data by the first parameter vector;

wherein, the affine transformation matrix is an N×N matrix, when the affine transformation matrix corresponding to the to-be- acquired data is the k-th affine transformation matrix, the element $a_{ij}$ in each of the N affine transformation matrices corresponding to the to-be- acquired data satisfies:

$$a_{ij} = \begin{cases} 1, & j \geq k \ \text{and} \ j - i \ = \ k - 1 \\ 1, & j < k \ and \ j - i \ = \ k - 1 - N \\ 0, & \text{other} \end{cases}.$$

In an embodiment, the permutation module may be specifically configured to:

exchange the value of the dimension corresponding to the identifier of the to-be-acquired data in the first parameter vector with the value of the first dimension in the first parameter vector, to obtain the N-dimensional second parameter vectors corresponding to the to-be-acquired data.

In an embodiment, exchanging the value of the dimension corresponding to the identifier of the to-be-acquired data in the first parameter vector with the value of the first dimension in the first parameter vector, to obtain the N-dimensional second parameter vectors corresponding to the to-be-acquired data may include:

performing N-dimensional permutation on the first parameter vector according to the affine transformation matrix corresponding to the to-be- acquired data, such that: when the affine transformation matrix corresponding to the to-be- acquired data is the k-th affine transformation matrix, when k is equal to 1, the N-dimensional second parameter vector corresponding to the to-be- acquired data is equal to the first parameter vector; when k is not equal to 1, the N-dimensional second parameter vectors corresponding to the to-be-acquired data are obtained by exchanging the k-th element of the first parameter vector with the first element, wherein $k$=1,...N, $k$ represents the identifier of the to-be-acquired data.

In an embodiment, the permutation module may be specifically configured to:

multiply the affine transformation matrix corresponding to the to-be- acquired data by the first parameter vector;

wherein, the affine transformation matrix is an N×N matrix, when the affine transformation matrix corresponding to the to-be- acquired data is the k-th affine transformation matrix, the element $a_{ij}$ in each of the N affine transformation matrices corresponding to the to-be- acquired data satisfies:

$$a_{1k} = 1;$$

$$a_{k1} = 1;$$

$$a_{ij} = \begin{cases} 1, & i \neq 1, k, \text{and } i = j \\ 0, & \text{other} \end{cases}$$

An embodiment of the present application also provides a computer program, which implements the following steps when the computer program is executed by a processor as defined in claim 12.

For the device/electronic device/storage medium/computer program embodiments, since they are basically similar to the method embodiments, the description is relatively simple, and the relevant parts can be referred to the part of the description of the method embodiment.

It should be noted that although the present application is described with data storage and acquisition as examples, it should be understood that this application is not only used for data storage, but also can be applied to data characterization, for example, to represent complex data information by simplified data information, and it can also be configured to reduce data dimensions, for example, reducing high-dimensional data to low-dimensional data.

It should be noted that, relationship terms such as "first," "second" and the like are only configured to distinguish one entity or operation from another entity or operation, and do not necessarily require or imply that there is any such actual relationship or order between those entities or operations. Moreover, the terms "include," "comprise" or any other variants are intended to cover a non-exclusive inclusion, such that processes, methods, objects or devices comprising a series of elements include not only those elements, but also other elements not specified or the elements inherent to those processes, methods, objects, or devices. Without further limitations, an element limited by the phrase "comprise(s) a... " do not exclude that there are other identical elements in the processes, methods, objects, or devices that comprise that element.

**Claims**

1. A data storage method, wherein the method comprises:

allocating an N-dimensional first parameter vector for N pieces of to-be-stored data; wherein initial values of parameters of each dimension in the first parameter vector are obtained by sampling the N pieces of to-be-stored data according to Gaussian distribution random values;
performing N-dimensional permutation on the first parameter vector, to obtain N second parameter vectors each having N dimensions; wherein the performing comprises: performing N-dimensional permutation on the first parameter vector through N affine transformation matrices to obtain N second parameter vectors each having N dimensions, such that one of the N second parameter vectors each having N dimensions is the same as the first parameter vector, and values of the other second parameter vectors in each dimension are different from a value of the first parameter vector in the corresponding dimension; the affine transformation matrices are generated online according to the current k value, where $k=1,...N$;

constructing a neural network model that maps the current second parameter vectors to expected data samples of the N pieces of to-be-stored data; wherein, the neural network model is a deep learning neural network model; adjusting model parameters of the neural network model and/or the first parameter vector until expected data samples of the N pieces of to-be-stored data regress to the N pieces of to-be-stored data, the expected data samples being obtained from the current second parameter vectors based on a trained neural network model; wherein the adjusting comprises: training the model parameters of the neural network model by using the N second parameter vectors each having N dimensions as input variables of the neural network model and using output data of the neural network model as the expected data samples of the N pieces of to-be-stored data, and/or updating the first parameter vector during the training process, until the expected data samples of the N pieces of to-be-stored data regress to the N pieces of to-be-stored data;

wherein, the training comprises: initializing the model parameters of the neural network model; accumulating current number of iterations; inputting the current second parameter vectors into the current neural network model to obtain current expected data samples of the N pieces of to-be-stored data, calculating a loss function of the current expected data sample and the N pieces of to-be-stored data, wherein the loss function is a regression loss function; and optimizing the model parameters and/or the first parameter vector of the current neural network model according to the principle of making the loss function converge, to obtain model parameters of the neural network model optimized for this iteration and/or the updated first parameter vector; using the second parameter vectors after the previous iteration as the current second parameter vectors, or performing N-dimensional permutation on the adjusted first parameter vector to obtain the second parameter vectors; returning to execute the step of accumulating the current number of iterations until the current number of iterations reaches a predetermined number of iterations, or the loss function converges to a predetermined threshold, to obtain model parameters of the trained neural network model and/or the updated first parameter vector;

storing the updated first parameter vector on a storage device;

wherein the method further comprises: classifying the N pieces of to-be-stored data according to categories, and/or assigning an identifier for each piece of the to-be-stored data and storing a corresponding relationship between the category and/or identifier and the first parameter vector;

the method further comprises: storing the model parameters of the trained neural network model on the storage device.

2. The method according to claim 1, wherein it further comprises:
performing N-dimensional permutation on the current first parameter vector and returning to execute the step of adjusting the model parameters of the neural network model and/or the first parameter vector if the expected data samples of the N pieces of to-be-stored data do not regress to the N pieces of to-be-stored data, wherein the expected data samples are obtained from the current second parameter vectors based on the trained neural network model.

3. The method according to claim 1, wherein the performing N-dimensional permutation on the first parameter vector to obtain N second parameter vectors each having N dimensions comprises:
exchanging, for each of the N pieces of to-be-stored data, a value of a dimension corresponding to the identifier of each piece of the to-be-stored data in the first parameter vector with a value of a first dimension in the first parameter vector, to obtain N second parameter vectors each having N dimensions.

4. The method according to claim 1, wherein the performing N-dimensional permutation on the first parameter vector through N affine transformation matrices to obtain N second parameter vectors each having N dimensions, such that one of the N second parameter vectors each having N dimensions is the same as the first parameter vector, and values of the other second parameter vectors in each dimension are different from a value of the first parameter vector in the corresponding dimension comprises:
performing N-dimensional permutation on the first parameter vector through N affine transformation matrices respectively, such that for the k-th affine transformation matrix, when k is equal to 1, the second parameter vector is equal to the first parameter vector; when k is not equal to 1, the first k-1 elements of the first parameter vector are placed at the end of the first parameter respectively, to obtain N-1 second parameter vectors each having N dimensions, where $k=1,...N$.

5. The method according to claim 3, wherein, the exchanging, for each of the N pieces of to-be-stored data, a value of a dimension corresponding to the identifier of each piece of the to-be-stored data in the first parameter vector with a value of a first dimension in the first parameter vector, to obtain N second parameter vectors each having N dimensions comprises:
performing N-dimensional permutation on the first parameter vector through N affine transformation matrices respectively, such that for the $k$-th affine transformation matrix, when $k$ is equal to 1, the second parameter vector is equal to the first parameter vector; when $k$ is not equal to 1, the $k$-th element of the first parameter vector is exchanged with the first element, to obtain N-1 second parameter vectors each having N dimensions, where $k$ represents an identifier of to-be-stored data, $k$=1,...N.

6. The method according to claim 1, wherein the method comprises:

obtaining the stored first parameter vector according to categories and/or identifiers of the to-be-acquired data based on the corresponding relationship between the categories and/or identifiers and the first parameter vector; performing N-dimensional permutation on the obtained first parameter vector to obtain N second parameter vectors each having N dimensions, where N is the number of dimensions of the obtained first parameter vector; wherein the performing comprises: performing N-dimensional permutation on the obtained first parameter vector through N affine transformation matrices to obtain N second parameter vectors each having N dimensions, such that one of the N second parameter vectors each having N dimensions is the same as the obtained first parameter vector, and values of the other second parameter vectors in each dimension are different from a value of the obtained first parameter vector in the corresponding dimension; obtaining stored model parameters of the trained neural network model, and loading the obtained model parameters into the neural network model to obtain the trained neural network model used for data storage; using the N second parameter vectors as input variables of the trained neural network model, and using output data of the trained neural network model as the to-be-acquired data.

7. The method according to claim 6, wherein the performing N-dimensional permutation on the obtained first parameter vector to obtain N second parameter vectors each having N dimensions comprises:
exchanging a value of a dimension corresponding to the identifier of the to-be-acquired data in the obtained first parameter vector with a value of a first dimension in the obtained first parameter vector, to obtain N second parameter vectors each having N dimensions.

8. The method according to claim 7, wherein, the performing N-dimensional permutation on the obtained first parameter vector through N affine transformation matrices to obtain N second parameter vectors each having N dimensions, such that one of the N second parameter vectors each having N dimensions is the same as the obtained first parameter vector, and values of the other second parameter vectors in each dimension are different from a value of the obtained first parameter vector in the corresponding dimension comprises:
performing N-dimensional permutation on the obtained first parameter vector through N affine transformation matrices respectively, such that for the $k$-th affine transformation matrix, when $k$ is equal to 1, the second parameter vector is equal to the obtained first parameter vector; when $k$ is not equal to 1, the first $k$-1 elements of the obtained first parameter vector are placed at the end of the first parameter respectively, to obtain N-1 second parameter vectors each having N dimensions, where $k$=1,...N.

9. The method according to claim 7, wherein, the exchanging comprises:
performing N-dimensional permutation on the obtained first parameter vector through N affine transformation matrices respectively, such that for the k-th affine transformation matrix, when k is equal to 1, the second parameter vector is equal to the obtained first parameter vector; when $k$ is not equal to 1, the $k$-th element of the obtained first parameter vector is exchanged with the first element, to obtain N-1 second parameter vectors each having N dimensions, where $k$ represents the identifier of to-be-acquired data, $k$=1,...N.

10. A data storage device, comprising:

an allocation module, configured for allocating an N-dimensional first parameter vector for N pieces of to-be-stored data; wherein initial values of parameters of each dimension in the first parameter vector are obtained by sampling the N pieces of to-be-stored data according to Gaussian distribution random values; a first permutation module, configured for performing N-dimensional permutation on the first parameter vector through N affine transformation matrices to obtain N second parameter vectors each having N dimensions, such that one of the N second parameter vectors each having N dimensions is the same as the first parameter vector, and values of the other second parameter vectors in each dimension are different from a value of the first parameter vector in the corresponding dimension; wherein the affine transformation matrices are generated online according to the current $k$ value, where $k$=1,...N;

a construction module, configured for constructing a neural network model that maps the current second parameter vectors to expected data samples of the N pieces of to-be-stored data, wherein, the neural network model is a deep learning neural network model; training the model parameters of the neural network model by using the N second parameter vectors each having N dimensions as input variables of the neural network model and using output data of the neural network model as the expected data samples of the N pieces of to-be-stored data, and/or updating the first parameter vector during the training process, until the expected data samples of the N pieces of to-be-stored data regress to the N pieces of to-be-stored data;

wherein the construction module is further configured for: initializing the model parameters of the neural network model; accumulating current number of iterations; inputting the current second parameter vectors into the current neural network model to obtain current expected data samples of the N pieces of to-be-stored data, calculating a loss function of the current expected data sample and the N pieces of to-be-stored data, wherein the loss function is a regression loss function; and optimizing the model parameters and/or the first parameter vector of the current neural network model according to the principle of making the loss function converge, to obtain model parameters of the neural network model optimized for this iteration and/or the updated first parameter vector; using the second parameter vectors after the previous iteration as the current second parameter vectors, or performing N-dimensional permutation on the adjusted first parameter vector to obtain the second parameter vectors; returning to execute the step of accumulating the current number of iterations until the current number of iterations reaches a predetermined number of iterations, or the loss function converges to a predetermined threshold, to obtain model parameters of a trained neural network model and/or the updated first parameter vector;

a storage module, configured for storing the updated first parameter vector and storing the model parameters of the trained neural network model;

a classification module, configured for classifying the N pieces of to-be-stored data according to categories, and/or assigning an identifier for each piece of the to-be-stored data and storing a corresponding relationship between the category and/or identifier and the first parameter vector.

11. The device according to claim 10, wherein the device further comprises:

a first obtaining module, configured for obtaining a stored first parameter vector according to categories and/or identifiers of to-be-acquired data based on a corresponding relationship between the stored categories and/or identifiers and the first parameter vector;

a second permutation module, configured for performing N-dimensional permutation on the obtained first parameter vector through N affine transformation matrices to obtain N second parameter vectors each having N dimensions, such that one of the N second parameter vectors each having N dimensions is the same as the obtained first parameter vector, and values of the other second parameter vectors in each dimension are different from a value of the obtained first parameter vector in the corresponding dimension, where N is the number of dimensions of the obtained first parameter vector;

a neural network model module, configured for: obtaining stored model parameters of the trained neural network model, and loading the obtained model parameters into the neural network model to obtain the trained neural network model used for data storage;

a second obtaining module, configured for using the N second parameter vectors as input variables of the trained neural network model, and using output data of the trained neural network model as the to-be-acquired data.

12. A computer readable storage medium, wherein a computer program is stored in the computer readable storage medium, the computer program implements the steps of the method according to any one of claims 1-9 when being executed by a processor.

**Patentansprüche**

1. Datenspeicherverfahren, wobei das Verfahren Folgendes umfasst:

Zuweisen eines N-dimensionalen ersten Parametervektors für N zu speichernde Daten; wobei Anfangswerte von Parametern jeder Dimension im ersten Parametervektor durch Abtasten der N zu speichernden Daten gemäß Zufallswerten einer Gaußschen Verteilung erhalten werden;

Durchführen einer N-dimensionalen Permutation des ersten Parametervektors, um N zweite Parametervektoren zu erhalten, die jeweils N Dimensionen aufweisen; wobei das Durchführen Folgendes umfasst: Durchführen einer N-dimensionalen Permutation auf dem ersten Parametervektor durch N affine Transformationsmatrizen, um N zweite Parametervektoren mit jeweils N Dimensionen zu erhalten, so dass einer der N zweiten Parametervektoren mit jeweils N Dimensionen mit dem ersten Parametervektor identisch ist und die Werte der anderen zweiten Parametervektoren in jeder Dimension sich von einem Wert des ersten Parametervektors in der entsprechenden Dimension unterscheiden; die affinen Transformationsmatrizen werden online gemäß dem aktuellen k-Wert erzeugt, wobei $k=1,...N$;

Konstruieren eines neuronalen Netzwerkmodells, das die aktuellen zweiten Parametervektoren auf erwartete Datenproben der N zu speichernden Daten abbildet; wobei das neuronale Netzwerkmodell ein Deep-Learning-Neuronales-Netzwerkmodell ist;

Anpassen der Modellparameter des neuronalen Netzmodells und/oder des ersten Parametervektors, bis die erwarteten Datenproben der N zu speichernden Daten auf die N zu speichernden Daten zurückgeführt werden, wobei die erwarteten Datenproben aus den aktuellen zweiten Parametervektoren auf der Grundlage eines trainierten neuronalen Netzmodells erhalten werden; wobei das Anpassen Folgendes umfasst: Trainieren der Modellparameter des neuronalen Netzmodells unter Verwendung der N zweiten Parametervektoren, die jeweils N Dimensionen aufweisen, als Eingabevariablen des neuronalen Netzmodells und unter Verwendung der Ausgabedaten des neuronalen Netzmodells als erwartete Datenproben der N zu speichernden Daten, und/oder Aktualisieren des ersten Parametervektors während des Trainingsprozesses, bis die erwarteten Datenproben der N zu speichernden Daten auf die N zu speichernden Daten zurückgeführt werden;

wobei das Trainieren Folgendes umfasst: Initialisieren der Modellparameter des neuronalen Netzmodells; Akkumulieren der aktuellen Anzahl von Iterationen; Eingeben der aktuellen zweiten Parametervektoren in das aktuelle neuronale Netzmodell, um aktuelle erwartete Datenproben der N zu speichernden Daten zu erhalten; Berechnen einer Verlustfunktion der aktuellen erwarteten Datenprobe und der N zu speichernden Daten, wobei die Verlustfunktion eine Regressionsverlustfunktion ist; und Optimieren der Modellparameter und/oder des ersten Parametervektors des aktuellen neuronalen Netzmodells gemäß dem Prinzip der Konvergenz der Verlustfunktion, um die für diese Iteration optimierten Modellparameter des neuronalen Netzmodells und/oder den aktualisierten ersten Parametervektor zu erhalten; Verwenden der zweiten Parametervektoren nach der vorherigen Iteration als aktuelle zweite Parametervektoren oder Durchführen einer N-dimensionalen Permutation des angepassten ersten Parametervektors, um die zweiten Parametervektoren zu erhalten; Zurückkehren zur Ausführung des Schritts des Akkumulierens der aktuellen Anzahl von Iterationen, bis die aktuelle Anzahl von Iterationen eine vorbestimmte Anzahl von Iterationen erreicht oder die Verlustfunktion zu einem vorbestimmten Schwellenwert konvergiert, um Modellparameter des trainierten neuronalen Netzmodells und/oder den aktualisierten ersten Parametervektor zu erhalten;

Speichern des aktualisierten ersten Parametervektors auf einer Speichervorrichtung;

wobei das Verfahren ferner Folgendes umfasst: Klassifizieren der N zu speichernden Datenstücke nach Kategorien und/oder Zuweisen einer Kennung für jedes zu speichernde Datenstück und Speichern einer entsprechenden Beziehung zwischen der Kategorie und/oder Kennung und dem ersten Parametervektor;

das Verfahren ferner Folgendes umfasst: Speichern der Modellparameter des trainierten neuronalen Netzmodells auf der Speichervorrichtung.

2. Verfahren nach Anspruch 1, wobei es ferner umfasst:
Durchführen einer N-dimensionalen Permutation an dem aktuellen ersten Parametervektor und Zurückkehren zur Ausführung des Schritts des Anpassens der Modellparameter des neuronalen Netzwerkmodells und/oder des ersten Parametervektors, wenn die erwarteten Datenproben der N zu speichernden Daten nicht zu den N zu speichernden Daten zurückkehren, wobei die erwarteten Datenproben aus den aktuellen zweiten Parametervektoren auf der Grundlage des trainierten neuronalen Netzwerkmodells erhalten werden.

3. Verfahren nach Anspruch 1, wobei das Durchführen einer N-dimensionalen Permutation an dem ersten Parametervektor, um N zweite Parametervektoren zu erhalten, die jeweils N Dimensionen aufweisen, umfasst:
Austauschen für jedes der N zu speichernden Datenelemente eines Wertes einer Dimension, welcher der Kennung jedes zu speichernden Datenelements im ersten Parametervektor entspricht, mit einem Wert einer ersten Dimension im ersten Parametervektor, um N zweite Parametervektoren zu erhalten, die jeweils N Dimensionen aufweisen.

4. Verfahren nach Anspruch 1, wobei das Durchführen einer N-dimensionalen Permutation des ersten Parametervektors durch N affine Transformationsmatrizen, um N zweite Parametervektoren mit jeweils N Dimensionen zu erhalten, so dass einer der N zweiten Parametervektoren mit jeweils N Dimensionen mit dem ersten Parametervektor übereinstimmt und die Werte der anderen zweiten Parametervektoren in jeder Dimension sich von einem Wert des ersten Parametervektors in der entsprechenden Dimension unterscheiden, Folgendes umfasst:
Durchführen einer N-dimensionalen Permutation des ersten Parametervektors durch jeweils N affine Transformationsmatrizen, sodass für die k-te affine Transformationsmatrix, wenn $k$ gleich 1 ist, der zweite Parametervektor gleich dem ersten Parametervektor ist; wenn k ungleich 1 ist, die ersten k-1 Elemente des ersten Parametervektors jeweils an das Ende des ersten Parameters gesetzt werden, um N-1 zweite Parametervektoren mit jeweils N Dimensionen zu erhalten, wobei $k$=1,...N ist.

5. Verfahren nach Anspruch 3, wobei für jedes der N zu speichernden Datenelemente ein Wert einer Dimension, der der Kennung jedes zu speichernden Datenelements im ersten Parametervektor entspricht, durch einen Wert einer ersten Dimension im ersten Parametervektor ersetzt wird, um N zweite Parametervektoren mit jeweils N Dimensionen zu erhalten, Folgendes umfasst:
Durchführen einer N-dimensionalen Permutation des ersten Parametervektors durch jeweils N affine Transformationsmatrizen, sodass für die k-te affine Transformationsmatrix, wenn $k$ gleich 1 ist, der zweite Parametervektor gleich dem ersten Parametervektor ist; wenn $k$ ungleich 1 ist, das $k$-te Element des ersten Parametervektors mit dem ersten Element ausgetauscht wird, um N-1 zweite Parametervektoren mit jeweils N Dimensionen zu erhalten, wobei $k$ eine Kennung der zu speichernden Daten darstellt, $k$ = 1, ... N.

6. Verfahren nach Anspruch 1, wobei das Verfahren Folgendes umfasst:

Erhalten des gespeicherten ersten Parametervektors gemäß Kategorien und/oder Kennungen der zu erfassenden Daten auf der Grundlage der entsprechenden Beziehung zwischen den Kategorien und/oder Kennungen und dem ersten Parametervektor;
Durchführen einer N-dimensionalen Permutation an dem erhaltenen ersten Parametervektor, um N zweite Parametervektoren zu erhalten, die jeweils N Dimensionen aufweisen, wobei N die Anzahl der Dimensionen des erhaltenen ersten Parametervektors ist; wobei das Durchführen Folgendes umfasst: Durchführen einer N-dimensionalen Permutation an dem erhaltenen ersten Parametervektor durch N affine Transformationsmatrizen, um N zweite Parametervektoren mit jeweils N Dimensionen zu erhalten, so dass einer der N zweiten Parametervektoren mit jeweils N Dimensionen mit dem erhaltenen ersten Parametervektor identisch ist und die Werte der anderen zweiten Parametervektoren in jeder Dimension sich von einem Wert des erhaltenen ersten Parametervektors in der entsprechenden Dimension unterscheiden;
Erhalten der gespeicherten Modellparameter des trainierten neuronalen Netzmodells und Laden der erhaltenen Modellparameter in das neuronale Netzmodell, um das trainierte neuronale Netzmodell zu erhalten, das für die Datenspeicherung verwendet wird;
Verwenden der N-Sekunden-Parametervektoren als Eingabevariablen des trainierten neuronalen Netzmodells und Verwenden der Ausgabedaten des trainierten neuronalen Netzmodells als zu erfassende Daten.

7. Verfahren nach Anspruch 6, wobei das Durchführen einer N-dimensionalen Permutation an dem erhaltenen ersten Parametervektor, um N zweite Parametervektoren zu erhalten, die jeweils N Dimensionen aufweisen, Folgendes umfasst:
Austauschen eines Wertes einer Dimension, die der Kennung der zu erfassenden Daten im erhaltenen ersten Parametervektor entspricht, mit einem Wert einer ersten Dimension im erhaltenen ersten Parametervektor, um N zweite Parametervektoren zu erhalten, die jeweils N Dimensionen aufweisen.

8. Verfahren nach Anspruch 7, wobei das Durchführen einer N-dimensionalen Permutation des erhaltenen ersten Parametervektors durch N affine Transformationsmatrizen, um N zweite Parametervektoren mit jeweils N Dimensionen zu erhalten, so dass einer der N zweiten Parametervektoren mit jeweils N Dimensionen mit dem erhaltenen ersten Parametervektor übereinstimmt und die Werte der anderen zweiten Parametervektoren in jeder Dimension sich von einem Wert des erhaltenen ersten Parametervektors in der entsprechenden Dimension unterscheiden, Folgendes umfasst:
Durchführen einer N-dimensionalen Permutation des erhaltenen ersten Parametervektors durch jeweils N affine Transformationsmatrizen, sodass für die k-te affine Transformationsmatrix, wenn k gleich 1 ist, der zweite Parametervektor gleich dem erhaltenen ersten Parametervektor ist; wenn k ungleich 1 ist, die ersten k-1 Elemente des erhaltenen ersten Parametervektors jeweils am Ende des ersten Parameters platziert werden, um N-1 zweite Parametervektoren mit jeweils N Dimensionen zu erhalten, wobei $k$ = 1, ... N ist.

9. Verfahren nach Anspruch 7, wobei das Austauschen Folgendes umfasst:
Durchführen einer N-dimensionalen Permutation des erhaltenen ersten Parametervektors durch jeweils N affine Transformationsmatrizen, sodass für die $k$-te affine Transformationsmatrix, wenn $k$ gleich 1 ist, der zweite Parametervektor gleich dem erhaltenen ersten Parametervektor ist; wenn k ungleich 1 ist, das k-te Element des erhaltenen ersten Parametervektors mit dem ersten Element ausgetauscht wird, um N-1 zweite Parametervektoren mit jeweils N Dimensionen zu erhalten, wobei $k$ die Kennung der zu erfassenden Daten darstellt, $k$ = 1, ... N.

10. Datenspeichervorrichtung, umfassend:

ein Zuweisungsmodul, das zum Zuweisen eines N-dimensionalen ersten Parametervektors für N zu speichernde Daten konfiguriert ist; wobei Anfangswerte von Parametern jeder Dimension im ersten Parametervektor durch Abtasten der N zu speichernden Daten gemäß Gaußschen Zufallswerten erhalten werden;

ein erstes Permutationsmodul, das so konfiguriert ist, dass es eine N-dimensionale Permutation des ersten Parametervektors durch N affine Transformationsmatrizen durchführt, um N zweite Parametervektoren mit jeweils N Dimensionen zu erhalten, sodass einer der N zweiten Parametervektoren mit jeweils N Dimensionen mit dem ersten Parametervektor identisch ist, und die Werte der anderen zweiten Parametervektoren in jeder Dimension sich von einem Wert des ersten Parametervektors in der entsprechenden Dimension unterscheiden; wobei die affinen Transformationsmatrizen online gemäß dem aktuellen k -Wert erzeugt werden, wobei $k = 1, ... N$;

ein Konstruktionsmodul, das zum Konstruieren eines neuronalen Netzwerkmodells konfiguriert ist, das die aktuellen Sekundenparametervektoren auf erwartete Datenproben der N zu speichernden Daten abbildet, wobei das neuronale Netzwerkmodell ein Deep-Learning-Neuronales-Netzwerkmodell ist; Trainieren der Modellparameter des neuronalen Netzmodells unter Verwendung der N zweiten Parametervektoren, die jeweils N Dimensionen aufweisen, als Eingabevariablen des neuronalen Netzmodells und unter Verwendung der Ausgabedaten des neuronalen Netzmodells als erwartete Datenproben der N zu speichernden Daten, und/oder Aktualisieren des ersten Parametervektors während des Trainingsprozesses, bis die erwarteten Datenproben der N zu speichernden Daten zu den N zu speichernden Daten zurückkehren;

wobei das Konstruktionsmodul ferner konfiguriert ist für: Initialisieren der Modellparameter des neuronalen Netzwerkmodells; Akkumulieren der aktuellen Anzahl von Iterationen; Eingeben der aktuellen zweiten Parametervektoren in das aktuelle neuronale Netzwerkmodell, um aktuelle erwartete Datenproben der N zu speichernden Daten zu erhalten; Berechnen einer Verlustfunktion der aktuellen erwarteten Datenprobe und der N zu speichernden Daten; wobei die Verlustfunktion eine Regressionsverlustfunktion ist; und Optimieren der Modellparameter und/oder des ersten Parametervektors des aktuellen neuronalen Netzmodells gemäß dem Prinzip, die Verlustfunktion konvergieren zu lassen, um Modellparameter des neuronalen Netzmodells zu erhalten, die für diese Iteration optimiert sind, und/oder den aktualisierten ersten Parametervektor; Verwenden der zweiten Parametervektoren nach der vorherigen Iteration als aktuelle zweite Parametervektoren oder Durchführen einer N-dimensionalen Permutation des angepassten ersten Parametervektors, um die zweiten Parametervektoren zu erhalten; Zurückkehren zur Ausführung des Schritts des Akkumulierens der aktuellen Anzahl von Iterationen, bis die aktuelle Anzahl von Iterationen eine vorbestimmte Anzahl von Iterationen erreicht oder die Verlustfunktion zu einem vorbestimmten Schwellenwert konvergiert, um Modellparameter eines trainierten neuronalen Netzmodells und/oder den aktualisierten ersten Parametervektor zu erhalten;

ein Speichermodul, das zum Speichern des aktualisierten ersten Parametervektors und zum Speichern der Modellparameter des trainierten neuronalen Netzmodells konfiguriert ist;

ein Klassifizierungsmodul, das so konfiguriert ist, dass es die N zu speichernden Datenstücke nach Kategorien klassifiziert und/oder jedem zu speichernden Datenstück eine Kennung zuweist und eine entsprechende Beziehung zwischen der Kategorie und/oder Kennung und dem ersten Parametervektor speichert.

11. Vorrichtung nach Anspruch 10, wobei die Vorrichtung ferner umfasst:

ein erstes Erfassungsmodul, das so konfiguriert ist, dass es einen gespeicherten ersten Parametervektor gemäß Kategorien und/oder Kennungen von zu erfassenden Daten auf der Grundlage einer entsprechenden Beziehung zwischen den gespeicherten Kategorien und/oder Kennungen und dem ersten Parametervektor erfasst;

ein zweites Permutationsmodul, das so konfiguriert ist, dass es eine N-dimensionale Permutation des erhaltenen ersten Parametervektors durch N affine Transformationsmatrizen durchführt, um N zweite Parametervektoren mit jeweils N Dimensionen zu erhalten, sodass einer der N zweiten Parametervektoren mit jeweils N Dimensionen mit dem erhaltenen ersten Parametervektor identisch ist, und die Werte der anderen zweiten Parametervektoren in jeder Dimension sich von einem Wert des erhaltenen ersten Parametervektors in der entsprechenden Dimension unterscheiden, wobei N die Anzahl der Dimensionen des erhaltenen ersten Parametervektors ist;

ein neuronales Netzwerkmodellmodul, das konfiguriert ist, um: gespeicherte Modellparameter des trainierten neuronalen Netzwerkmodells zu erhalten und die erhaltenen Modellparameter in das neuronale Netzwerkmodell zu laden, um das trainierte neuronale Netzwerkmodell zu erhalten, das für die Datenspeicherung verwendet wird;

ein zweites Erhaltungsmodul, das so konfiguriert ist, dass es die N zweiten Parametervektoren als Eingabevariablen des trainierten neuronalen Netzmodells verwendet und die Ausgabedaten des trainierten neuronalen Netzmodells als die zu erfassenden Daten verwendet.

**12.** Computerlesbares Speichermedium, wobei ein Computerprogramm auf dem computerlesbaren Speichermedium gespeichert ist, wobei das Computerprogramm die Schritte des Verfahrens nach einem der Ansprüche 1 bis 9 ausführt, wenn es von einem Prozessor ausgeführt wird.

**Revendications**

**1.** Procédé de stockage de données, dans lequel le procédé comprend :

l'attribution d'un premier vecteur de paramètres N-dimensionnel pour N éléments de données à stocker ; dans lequel des valeurs initiales de paramètres de chaque dimension dans le premier vecteur de paramètres sont obtenues en échantillonnant les N éléments de données à stocker selon des valeurs aléatoires de distribution gaussienne ;
la réalisation d'une permutation N-dimensionnelle sur le premier vecteur de paramètres afin d'obtenir N seconds vecteurs de paramètres présentant chacun N dimensions ; dans lequel la réalisation comprend : la réalisation d'une permutation N-dimensionnelle sur le premier vecteur de paramètres au moyen de N matrices de transformation affine pour obtenir N seconds vecteurs de paramètres présentant chacun N dimensions, de sorte qu'un des N seconds vecteurs de paramètres présentant chacun N dimensions est identique au premier vecteur de paramètres, et des valeurs des autres seconds vecteurs de paramètres, dans chaque dimension, diffèrent d'une valeur du premier vecteur de paramètres dans la dimension correspondante ; les matrices de transformation affine sont générées en ligne en fonction de la valeur de k actuelle, où $k$ = 1, ...N;
construction d'un modèle de réseau neuronal qui mappe les seconds vecteurs de paramètres actuels aux échantillons de données attendus des N éléments de données à stocker ; dans lequel le modèle de réseau neuronal est un modèle de réseau neuronal d'apprentissage profond ;
l'ajustement de paramètres de modèle du modèle de réseau neuronal et/ou du premier vecteur de paramètres jusqu'à ce que des échantillons de données attendus des N éléments de données à stocker régressent vers les N éléments de données à stocker, les échantillons de données attendus étant obtenus à partir des seconds vecteurs de paramètres actuels sur la base d'un modèle de réseau neuronal entraîné ; dans lequel l'ajustement comprend : l'entraînement des paramètres de modèle du modèle de réseau neuronal en utilisant les N seconds vecteurs de paramètres présentant chacun N dimensions, comme variables d'entrée du modèle de réseau neuronal et en utilisant des données de sortie du modèle de réseau neuronal comme les échantillons de données attendus des N éléments de données à stocker, et/ou la mise à jour du premier vecteur de paramètres pendant le processus d'entraînement, jusqu'à ce que les échantillons de données attendus des N éléments de données à stocker régressent vers les N éléments de données à stocker ;
dans lequel l'entraînement comprend : l'initialisation des paramètres de modèle du modèle de réseau neuronal ; l'accumulation d'un nombre actuel d'itérations ; l'injection des seconds vecteurs de paramètres actuels dans le modèle de réseau neuronal afin d'obtenir des échantillons de données attendus actuels des N éléments de données à stocker, le calcul d'une fonction de perte de l'échantillon de données attendu actuel et des N éléments de données à stocker, dans lequel la fonction de perte est une fonction de perte de régression ; et l'optimisation des paramètres de modèle et/ou du premier vecteur de paramètres du modèle de réseau neuronal actuel, selon le principe de convergence de la fonction de perte, afin d'obtenir des paramètres de modèle du modèle de réseau neuronal optimisés pour cette itération et/ou le premier vecteur de paramètres mis à jour ; l'utilisation des seconds vecteurs de paramètres après l'itération précédente comme les seconds vecteurs de paramètres actuels, ou la réalisation d'une permutation N-dimensionnelle sur le premier vecteur de paramètres ajusté pour obtenir les seconds vecteurs de paramètres ; le retour à l'exécution de l'étape d'accumulation du nombre actuel d'itérations jusqu'à ce que le nombre actuel d'itérations atteigne un nombre prédéterminé d'itérations, ou que la fonction de perte converge vers un seuil prédéterminé, afin d'obtenir des paramètres de modèle du modèle de réseau neuronal entraîné et/ou le premier vecteur de paramètres mis à jour ;
le stockage du premier vecteur de paramètres mis à jour sur un dispositif de stockage;
dans lequel le procédé comprend en outre : la classification des N éléments de données à stocker selon des catégories, et/ou l'attribution d'un identifiant à chaque élément des données à stocker et le stockage d'une relation correspondante entre la catégorie et/ou l'identifiant et le premier vecteur de paramètres ;
le procédé comprend en outre : le stockage des paramètres de modèle du modèle de réseau neuronal entraîné sur le dispositif de stockage.

**2.** Procédé selon la revendication 1, dans lequel il comprend en outre :
la réalisation d'une permutation N-dimensionnelle sur le premier vecteur de paramètres actuel et le retour à l'exécution de l'étape d'ajustement des paramètres de modèle du modèle de réseau neuronal et/ou du premier vecteur de paramètres si les échantillons de données attendus des N éléments de données à stocker ne régressent pas vers les N éléments de données à stocker, dans lequel les échantillons de données attendus sont obtenus à partir des seconds vecteurs de paramètres actuels sur la base du modèle de réseau neuronal entraîné.

3. Procédé selon la revendication 1, dans lequel la réalisation de la permutation N-dimensionnelle sur le premier vecteur de paramètres pour obtenir N seconds vecteurs de paramètres présentant chacun N dimensions, comprend :
l'échange, pour chacun des N éléments de données à stocker, d'une valeur d'une dimension correspondant à l'identifiant de chaque élément des donnée à stocker dans le premier vecteur de paramètres avec une valeur d'une première dimension dans le premier vecteur de paramètres, pour obtenir N seconds vecteurs de paramètres présentant chacun N dimensions.

4. Procédé selon la revendication 1, dans lequel la réalisation de la permutation N-dimensionnelle sur le premier vecteur de paramètres au moyen de N matrices de transformation affine pour obtenir N seconds vecteurs de paramètre présentant chacun N dimensions, de sorte que l'un des N seconds vecteurs de paramètres présentant chacun N dimensions soit identique au premier vecteur de paramètres, et que des valeurs des autres seconds vecteurs de paramètres dans chaque dimension soient différentes d'une valeur du premier vecteur de paramètres dans la dimension correspondante, comprend :
la réalisation d'une permutation N-dimensionnelle sur le premier vecteur de paramètres au moyen de N matrices de transformation affine respectivement, de sorte que pour la k-ième matrice de transformation affine, lorsque k est égal à 1, le second vecteur de paramètres est égal au premier vecteur de paramètres ; lorsque k n'est pas égal à 1, les $k - 1$ premiers éléments du premier vecteur de paramètres sont placés à la fin du premier paramètre respectivement, afin d'obtenir N - 1 seconds vecteurs de paramètres présentant chacun N dimensions, où $k$ = 1, ...N.

5. Procédé selon la revendication 3, dans lequel l'échange, pour chacun des N éléments de données à stocker, d'une valeur d'une dimension correspondant à l'identifiant de chaque élément des donnée à stocker dans le premier vecteur de paramètres avec une valeur d'une première dimension dans le premier vecteur de paramètres, afin d'obtenir N seconds vecteurs de paramètres présentant chacun N dimensions, comprend :
la réalisation d'une permutation N-dimensionnelle sur le premier vecteur de paramètres au moyen de N matrices de transformation affine respectivement, de sorte que pour la k-ième matrice de transformation affine, lorsque k est égal à 1, le second vecteur de paramètres est égal au premier vecteur de paramètres ; lorsque k n'est pas égal à 1, le k-ième élément du premier vecteur de paramètres est échangé avec le premier élément, afin d'obtenir N - 1 seconds vecteurs de paramètres présentant chacun N dimensions, où k représente un identifiant de données à stocker k = 1, ...N.

6. Procédé selon la revendication 1, dans lequel le procédé comprend :

l'obtention du premier vecteur de paramètres stocké selon des catégories et/ou des identifiants des données à acquérir sur la base de la relation correspondante entre les catégories et/ou les identifiants et le premier vecteur de paramètres ;
la réalisation d'une permutation N-dimensionnelle sur le premier vecteur de paramètres obtenu afin d'obtenir N seconds vecteurs de paramètres présentant chacun N dimensions, où N est le nombre de dimensions du premier vecteur de paramètres obtenu ; dans lequel la réalisation comprend : la réalisation d'une permutation N-dimensionnelle sur le premier vecteur de paramètres obtenu au moyen de N matrices de transformation affine pour obtenir N seconds vecteurs de paramètres présentant chacun N dimensions, de sorte qu'un des N seconds vecteurs de paramètres présentant chacun N dimensions est identique au premier vecteur de paramètres obtenu, et des valeurs des autres seconds vecteurs de paramètres, dans chaque dimension, diffèrent d'une valeur du premier vecteur de paramètres obtenu dans la dimension correspondante ;
l'obtention de paramètres de modèle stockés du modèle de réseau neuronal entraîné, et le chargement des paramètres de modèle obtenus dans le modèle de réseau neuronal pour obtenir le modèle de réseau neuronal entraîné utilisé pour le stockage de données ;
l'utilisation des N seconds vecteurs de paramètres comme variables d'entrée du modèle de réseau neuronal entraîné, et l'utilisation de données de sortie du modèle de réseau neuronal entraîné comme les données à acquérir.

7. Procédé selon la revendication 6, dans lequel la réalisation de la permutation N-dimensionnelle sur le premier vecteur de paramètres obtenu pour obtenir N seconds vecteurs de paramètres présentant chacun N dimensions, comprend :
l'échange d'une valeur d'une dimension correspondant à l'identifiant des données à acquérir dans le premier vecteur de paramètres obtenu avec une valeur d'une première dimension dans le premier vecteur de paramètres obtenu, pour obtenir N seconds vecteurs de paramètres présentant chacun N dimensions.

**8.** Procédé selon la revendication 7, dans lequel la réalisation de la permutation N-dimensionnelle sur le premier vecteur de paramètres obtenu au moyen de N matrices de transformation affine pour obtenir N seconds vecteurs de paramètre présentant chacun N dimensions, de sorte que l'un des N seconds vecteurs de paramètres présentant chacun N dimensions soit identique au premier vecteur de paramètres obtenu, et que des valeurs des autres seconds vecteurs de paramètres dans chaque dimension soient différentes d'une valeur du premier vecteur de paramètres obtenu dans la dimension correspondante, comprend :

la réalisation d'une permutation N-dimensionnelle sur le premier vecteur de paramètres obtenu au moyen de N matrices de transformation affine respectivement, de sorte que pour la k-ième matrice de transformation affine, lorsque k est égal à 1, le second vecteur de paramètres est égal au premier vecteur de paramètres obtenu ; lorsque k n'est pas égal à 1, les $k - 1$ premiers éléments du premier vecteur de paramètres obtenu sont placés à la fin du premier paramètre respectivement, afin d'obtenir N - 1 seconds vecteurs de paramètres présentant chacun N dimensions, où $k = 1, ...N$.

**9.** Procédé selon la revendication 7, dans lequel l'échange comprend :

la réalisation d'une permutation N-dimensionnelle sur le premier vecteur de paramètres obtenu au moyen de N matrices de transformation affine respectivement, de sorte que pour la k-ième matrice de transformation affine, lorsque k est égal à 1, le second vecteur de paramètres est égal au premier vecteur de paramètres obtenu ; lorsque k n'est pas égal à 1, le k-ième élément du premier vecteur de paramètres obtenu est échangé avec le premier élément, afin d'obtenir N - 1 seconds vecteurs de paramètres présentant chacun N dimensions, où k représente l'identifiant de données à acquérir k = 1, ...N.

**10.** Dispositif de stockage de données, comprenant :

un module d'attribution, configuré pour attribuer un premier vecteur de paramètres N-dimensionnel pour N éléments de données à stocker ; dans lequel des valeurs initiales de paramètres de chaque dimension dans le premier vecteur de paramètres sont obtenues en échantillonnant les N éléments de données à stocker selon des valeurs aléatoires de distribution gaussienne ;

un premier module de permutation, configuré pour réaliser une permutation N-dimensionnelle sur le premier vecteur de paramètres au moyen de N matrices de transformation affine pour obtenir N seconds vecteurs de paramètres présentant chacun N dimensions, de sorte qu'un des N seconds vecteurs de paramètres présentant chacun N dimensions est identique au premier vecteur de paramètres, et des valeurs des autres seconds vecteurs de paramètres, dans chaque dimension, diffèrent d'une valeur du premier vecteur de paramètres dans la dimension correspondante ; dans lequel les matrices de transformation affine sont générées en ligne en fonction de la valeur de $k$ actuelle, où $k = 1, ...N$ ;

un module de construction, configuré pour construire un modèle de réseau neuronal qui mappe les seconds vecteurs de paramètres actuels à des échantillons de données attendus des N éléments de données à stocker, dans lequel le modèle de réseau neuronal est un modèle de réseau neuronal d'entraînement profond ; l'entraînement des paramètres de modèle du modèle de réseau neuronal en utilisant les N seconds vecteurs de paramètres présentant chacun N dimensions, comme variables d'entrée du modèle de réseau neuronal et en utilisant des données de sortie du modèle de réseau neuronal comme les échantillons de données attendus des N éléments de données à stocker, et/ou la mise à jour du premier vecteur de paramètres pendant le processus d'entraînement, jusqu'à ce que les échantillons de données attendus des N éléments de données à stocker régressent vers les N éléments de données à stocker ;

dans lequel le module de construction est en outre configuré pour : initialiser les paramètres de modèle du modèle de réseau neuronal ; l'accumulation d'un nombre actuel d'itérations ; injecter les seconds vecteurs de paramètres actuels dans le modèle de réseau neuronal afin d'obtenir des échantillons de données attendus des N éléments de données à stocker, le calcul d'une fonction de perte des échantillons de données attendus actuels et des N éléments de données à stocker, dans lequel la fonction de perte est une fonction de perte de régression ; et optimiser les paramètres de modèle et/ou le premier vecteur de paramètres du modèle de réseau neuronal actuel, selon le principe de convergence de la fonction de perte, afin d'obtenir des paramètres de modèle du modèle de réseau neuronal optimisés pour cette itération et/ou le premier vecteur de paramètres mis à jour ; utiliser les seconds vecteurs de paramètres après l'itération précédente comme seconds vecteurs de paramètres actuels, ou la réalisation d'une permutation N-dimensionnelle sur le premier vecteur de paramètres ajusté pour obtenir les seconds vecteurs de paramètres ; retourner à l'exécution de l'étape d'accumulation du nombre actuel d'itérations jusqu'à ce que le nombre actuel d'itérations atteigne un nombre prédéterminé d'itérations, ou que la fonction de perte converge vers un seuil prédéterminé, afin d'obtenir des paramètres de modèle d'un modèle de réseau neuronal entraîné et/ou le premier vecteur de paramètres mis à jour ;

un module de stockage, configuré pour stocker le premier vecteur de paramètres mis à jour et stocker les paramètres de modèle du modèle de réseau neuronal entraîné ;

un module de classification, configuré pour classer les N éléments de données à stocker selon des catégories, et/ou l'attribution d'un identifiant à chaque élément des données à stocker et le stockage d'une relation correspondante entre la catégorie et/ou l'identifiant et le premier vecteur de paramètres ;

11. Dispositif selon la revendication 10, dans lequel le dispositif comprend en outre :

un premier module d'acquisition, configuré pour obtenir un premier vecteur de paramètres stocké selon des catégories et/ou des identifiants de données à acquérir sur la base d'une relation correspondante entre les catégories et/ou les identifiants stockés et le premier vecteur de paramètres ;

un second module de permutation, configuré pour réaliser une permutation N-dimensionnelle sur le premier vecteur de paramètres obtenu au moyen de N matrices de transformation affine pour obtenir N seconds vecteurs de paramètres présentant chacun N dimensions, de sorte que l'un des N seconds vecteurs de paramètres présentant chacun N dimensions soit identique au premier vecteur de paramètres obtenu, et que des valeurs des autres seconds vecteurs de paramètres dans chaque dimension soient différentes d'une valeur du premier vecteur de paramètres obtenu dans la dimension correspondante, où N est le nombre de dimensions du premier vecteur de paramètres obtenu ;

un module de modèle de réseau neuronal, configuré pour : obtenir des paramètres de modèle stockés du modèle de réseau neuronal entraîné, et le chargement des paramètres de modèle obtenus dans le modèle de réseau neuronal pour obtenir le modèle de réseau neuronal entraîné utilisé pour le stockage de données ;

un second module d'acquisition, configuré pour utiliser les N seconds vecteurs de paramètres comme variables d'entrée du modèle de réseau neuronal entraîné, et pour utiliser des données de sortie du modèle de réseau neuronal entraîné comme les données à acquérir.

12. Support de stockage lisible par ordinateur, dans lequel un programme informatique est stocké sur le support de stockage lisible par ordinateur, le programme informatique met en œuvre les étapes du procédé selon l'une quelconque des revendications 1-9 lorsqu'il est exécuté par un processeur.

Start

for to-be-stored data: classifying data according to categories, numbering the categories to obtain a category label; assigning an identifier ID to the characteristic data composed of a set of characteristic values in a same category of data as a sample identifier of the category data, or assigning an identifier directly — 101

allocating an N-dimensional first parameter vector for N pieces of sample data with different IDs — 102

performing permutation on the N different dimensions of the first parameter vector, to obtain N second parameter vectors each having N dimensions — 103

constructing a neural network model, training the neural network model, and/or updating the first parameter vector during the training process, such that the trained neural network model maps the second parameter vectors to sample data — 104

storing a corresponding relationship between the identifier ID and the first parameter vector, the first parameter vector, and the model parameters of the trained neural network model — 105

End

FIG. 1

configuring initial model parameters of the neural network model, mapping the second parameter vectors though the initial neural network model $f_0$ to obtain data samples

accumulating the current number of iterations $m$ — 201

calculating a loss function of the current neural network model, optimizing the model parameters of the current neural network model according to the principle of making the loss function converge and/or the first parameter vector, obtaining the current neural network model $f_m$ after this optimization, and/or updating the first parameter vector according to a learning result of the neural network model — 202

based on the optimized current neural network model $f_m$ and/or the updated first parameter vector, inputting the second parameter vectors or the updated second parameter vectors obtained by permutation based on the updated first parameter vector to the neural network model $f_m$, obtaining the current expected data sample — 203

reaching a preset number of iterations, or the loss function converges to a preset threshold

storing the current first parameter vector and the current model parameters

ending the training of the model

FIG. 2

$$h_1 = \begin{bmatrix} b_1 \\ b_1 \\ ... \\ b_N \end{bmatrix}$$

$x_1$
...
$x_{N-1}$
$x_N$

assigning

$$h_1 = \begin{bmatrix} b_1 \\ b_2 \\ ... \\ b_N \end{bmatrix}$$

permuting

$$h_2 = \begin{bmatrix} b_2 \\ ... \\ b_N \\ b_1 \end{bmatrix}$$

neural network output

$x_1$
...
$x_{N-1}$
$x_N$

...

$$h_N = \begin{bmatrix} b_N \\ b_1 \\ b_2 \\ ... \end{bmatrix}$$

FIG. 3

```
                                          ╭─────────────╮
                                          │ input data ID │
                                          ╰──────┬──────╯
                                                 │
                                                 ▼
┌─────────────────────────────┐    ┌──────────────────────────────┐
│        storage zone         │    │      obtaining first parameter │
│                             │    │   vector corresponding to an ID│
│                             │    │         according the ID       │
│ ┌─────────────────────────┐ │    └──────────────┬───────────────┘
│ │     correspondence      │ │                   │
│ │ between data ID and first│ │                  ▼
│ │    parameter vector     │ │    ┌──────────────────────────────┐
│ ├─────────────────────────┤ │    │     performing N-dimensional  │
│ │  first parameter vector │ │    │ permutation through an affine │
│ ├─────────────────────────┤ │    │ transformation matrix according to the │
│ │    model parameters     │ │    │  stored first parameter vector, to obtain │
│ └─────────────────────────┘ │    │     second parameter vectors  │
└─────────────────────────────┘    └──────────────┬───────────────┘
                                                   │
                                                   ▼
                                      ┌──────────────────────┐
                                      │     loading model     │
                                      │  parameters for neural │
                                      │     network model     │
                                      └───────────┬──────────┘
                                                  │
                                                  ▼
┌──────────────────────────────────────────────────────────────┐
│ using second parameter vectors as input variables of the neural│
│   network model algorithm, running neural network model       │
│  algorithm to obtain sample data that need to be acquired as   │
│                      output result                            │
└───────────────────────────┬──────────────────────────────────┘
                            │
                            ▼
                   ╭──────────────╮
                   │  end of data  │
                   │  acquisition  │
                   ╰──────────────╯
```

FIG. 4

```
┌─────────────┐            ┌─────────────┐
│    data     │            │             │
│identification│ ────────> │ allocation  │
│   module    │            │   module    │
└─────────────┘            └─────────────┘
                                  │
                                  ▼  ◄- - - - - - -┐
┌─────────────┐            ┌─────────────┐        ┊
│   affine    │            │             │        ┊
│transformation│           │  permutat   │        ┊    updating
│matrix online │ ────────> │ ion module  │        ┊  first parameter
│ generation  │            │             │        ┊      vector
│   module    │            └─────────────┘        ┊
└─────────────┘                   │               ┊
                                  ▼               ┊
┌─────────────┐            ┌─────────────┐        ┊       ┌─────────────┐
│  training   │            │neural network│- - - - ┘ ····>│   storage   │
│   module    │ ────────> │   module    │               │   module    │
└─────────────┘            └─────────────┘               └─────────────┘
```

FIG. 5

```
                        ┌─────────────┐
                        │    first    │
                        │parameter vector│
                        │obtaining module│
                        └─────────────┘
                                │
┌─────────────┐                 ▼
│   affine    │          ┌─────────────┐
│transformation│         │             │
│matrix online │ ──────> │ permutation │
│ generation  │          │   module    │
│   module    │          │             │
└─────────────┘          └─────────────┘
                                │
                                ▼
                        ┌─────────────┐
                        │neural network│
                        │model module │
                        └─────────────┘
```

FIG. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2004061702 A1